# EUROPÄISCHE PATENTSCHRIFT

(11) **EP 3 338 367 B1**
(45) Veröffentlichungstag und Bekanntmachung des Hinweises auf die Patenterteilung: **23.09.2020**
(21) Anmeldenummer: 16757609.9
(22) Anmeldetag: 18.08.2016
(51) Int. Cl.: H03K 17/96, H05K 1/03, B32B 17/10

(54) **SCHEIBENANORDNUNG MIT SCHEIBE MIT LOW-E-BESCHICHTUNG UND KAPAZITIVEM SCHALTBEREICH**
WINDOW PANE WITH CAPACITIVE RANGE AND LOW-E COATING
VITRE DE FENEÊTRE DOTÉE D'UNE ZONE DE COMMUTATION CAPACITIVE ET COUCHE A BASSE ÉMISSION

(30) Priorität: 18.08.2015 EP 15181324
(43) Veröffentlichungstag der Anmeldung: 27.06.2018
(73) Patentinhaber: SAINT-GOBAIN GLASS FRANCE, 92400 Courbevoie (FR)
(72) Erfinder: WEBER, Patrick, 52477 Alsdorf (DE); DROSTE, Stefan, 52134 Herzogenrath (DE); SCHMALBUCH, Klaus, 84220 Goult (DE); BAUERLE, Pascal, 80500 Davenescourt (FR)
(74) Vertreter: Gebauer, Dieter Edmund
(86) Internationale Anmeldenummer: PCT/EP2016/069660
(87) Internationale Veröffentlichungsnummer: WO 2017/029384

(56) Entgegenhaltungen:
- WO-A1-2013/053611
- US-A1- 2015 227 229

## Beschreibung

Die Erfindung betrifft eine Scheibenanordnung mit einer Scheibe mit einer Low-E-Beschichtung und einem kapazitiven Schaltbereich, sowie ein Verfahren zu deren Herstellung.

Der Innenraum eines Kraftfahrzeugs oder eines Gebäudes kann sich im Sommer bei hohen Umgebungstemperaturen und intensiver direkter Sonneneinstrahlung stark erwärmen. Ist beispielsweise die Außentemperatur geringer als die Temperatur in einem Fahrzeuginnenraum, was insbesondere im Winter auftritt, so wirkt eine kalte Fahrzeugscheibe als Wärmesenke, die von den Insassen als unangenehm empfunden wird. Auch muss eine hohe Heizleistung der Klimaanlage bereitgestellt werden, um eine Auskühlung des Innenraums über die Fahrzeugscheiben zu vermeiden.

Wärmestrahlung reflektierende Beschichtungen, sogenannte Low-E-Beschichtungen, sind beispielsweise aus WO 2013/131667 A1, US 20110146172 A2, EP 1 218 307 B1, EP 2 247 549 A2, WO 2014/127867 A1 und WO 2014/127868 A1 bekannt. Eine solche Low-E-Beschichtung reflektiert einen erheblichen Teil der Sonnenstrahlung, insbesondere im Infrarotbereich, was im Sommer zu einer verringerten Erwärmung, beispielsweise des Fahrzeuginnenraums, führt. Die Beschichtung verringert außerdem die Aussendung von langwelliger Wärmestrahlung einer erwärmten Scheibe in den Fahrzeuginnenraum hinein, wenn die Beschichtung auf der dem Fahrzeuginnenraum zugewandten Oberfläche einer Scheibe aufgebracht ist. Eine solche Low-E-Beschichtung verringert außerdem bei niedrigen Außentemperaturen im Winter die Abstrahlung der Wärme des Innenraums in die äußere Umgebung.

Des Weiteren ist bekannt, dass Schaltbereiche durch eine Flächenelektrode oder durch eine Anordnung von zwei gekoppelten Elektroden ausgebildet werden können, beispielsweise als kapazitive Schaltbereiche. Nähert sich ein Objekt dem Schaltbereich an, so ändert sich die Kapazität der Flächenelektrode gegen Erde oder die Kapazität des von den zwei gekoppelten Elektroden gebildeten Kondensators. Die Kapazitätsänderung wird über eine Schaltungsanordnung oder Sensorelektronik gemessen und bei Überschreiten eines Schwellwerts wird ein Schaltsignal ausgelöst. Schaltungsanordnungen für kapazitive Schalter sind beispielsweise aus DE 20 2006 006 192 U1, EP 0 899 882 A1, US 6,452,514 B1 und EP 1 515 211 A1 bekannt. Aus der US 2010/0179725 A1 ist beispielsweise eine Verbundverglasung mit einem innenliegenden, einlaminierten kapazitiven Sensor bekannt.

Die internationalen Patentanmeldungen WO 2013/053611 A1 und WO 2014/135467 A1 zeigen jeweils eine Low-E-Beschichtung mit einem kapazitiven Schalter.

Die Aufgabe der vorliegenden Erfindung besteht darin, eine verbesserte Scheibenanordnung bereitzustellen, die einen kapazitiven Schaltbereich aufweist, der einfach und kostengünstig in die Fensterscheibe integriert werden kann. Mit dem kapazitiven Schaltbereich kann in einfacher Weise ein Berührungssensor oder ein Annäherungssensor gebildet werden. Zudem soll die Signalqualität gegenüber herkömmlichen Schaltbereichen verbessert sein.

Diese und weitere Aufgaben der vorliegenden Erfindung werden erfindungsgemäß durch eine Scheibenanordnung gemäß dem unabhängigen Anspruch 1 gelöst. Bevorzugte Ausführungen gehen aus den Unteransprüchen hervor.

Die erfindungsgemäße Scheibenanordnung mit kapazitivem Schaltbereich umfasst zumindest:
Eine Scheibe, die über eine innenseitige Oberfläche (IV) und eine außenseitige Oberfläche (III) verfügt.

Eine Low-E-Beschichtung, die zumindest teilweise auf der innenseitigen Oberfläche (IV) der Scheibe angeordnet ist.

Mindestens eine in die Low-E-Beschichtung eingeformte, beschichtungsfreie erste Trennlinie, durch die mindestens ein von der Low-E-Beschichtung gebildeter, kapazitiver Schaltbereich von einem von der Low-E-Beschichtung gebildeten Umgebungsbereich elektrisch abgetrennt ist. Der Umgebungsbereich umgibt den kapazitiven Schaltbereich zumindest abschnittsweise, insbesondere vollständig. Falls sich der kapazitive Schaltbereich bis zum Rand der Low-E-Beschichtung erstreckt, dann umgibt der Umgebungsbereich den kapazitiven Schaltbereich nur abschnittsweise bzw. teilweise. In diesem Fall ist die erste Trennlinie nicht geschlossen und erstreckt sich frei endend bis zum Rand der Low-E-Beschichtung. Möglich ist jedoch auch, dass sich der kapazitive Schaltbereich vollständig innerhalb der Low-E-Beschichtung befindet, so dass der Umgebungsbereich den kapazitiven Schaltbereich vollständig umgibt. In diesem Fall ist die erste Trennlinie geschlossen. Der kapazitive Schaltbereich weist einen Berührungsbereich, einen Zuleitungsbereich und einen ersten Anschlussbereich auf, wobei der Zuleitungsbereich den Berührungsbereich mit dem ersten Anschlussbereich elektrisch verbindet.

Mindestens eine in die Low-E-Beschichtung eingeformte, beschichtungsfreie zweite Trennlinie, durch die der Umgebungsbereich von einem von der Low-E-Beschichtung gebildeten Außenbereich elektrisch abgetrennt ist. Der Außenbereich umgibt den Umgebungsbereich zumindest teilweise, insbesondere vollständig. Falls sich der Umgebungsbereich bis zum Rand der Low-E-Beschichtung erstreckt, dann umgibt der Außenbereich den Umgebungsbereich nur abschnittsweise bzw. teilweise. In diesem Fall ist die zweite Trennlinie nicht geschlossen und erstreckt sich frei endend bis zum Rand der Low-E-Beschichtung. Möglich ist jedoch auch, dass sich der Umgebungsbereich nicht bis zum Rand der Low-E-Beschichtung erstreckt, so dass der Außenbereich den Umgebungsbereich vollständig umgibt. In diesem Fall ist die zweite Trennlinie geschlossen.

Eine kapazitive Sensorelektronik, die mit dem ersten Anschlussbereich des kapazitiven Schaltbereichs und über einen zweiten Anschlussbereich mit dem Umgebungsbereich elektrisch verbunden ist.

Wie die Erfinder zeigen konnten, kann durch die Ausbildung eines Umgebungsbereichs der kleiner ist als der Bereich der Low-E-Beschichtung außerhalb des kapazitiven Schaltbereichs (d.h. vollständige Low-E-Beschichtung abzüglich des kapazitiven Schaltbereichs) in vorteilhafter Weise eine Erhöhung des Signal-/Rauschverhältnisses und somit eine Verbesserung des Schaltverhaltens des kapazitiven Schaltbereichs erreicht werden.

Die Scheibe bzw. Fensterscheibe der erfindungsgemäßen Scheibenanordnung ist zur Abtrennung eines Innenraums von einer äußeren Umgebung geeignet. Die Fensterscheibe kann vielfältig eingesetzt werden: Im Falle einer Fensterscheibe als Fahrzeugscheibe, kann sie beispielsweise eine Dachscheibe, eine Windschutzscheibe, eine Heckscheibe, eine Seitenscheibe oder eine andere den Fahrzeuginnenraum begrenzende Verglasung sein. Außenseitige Oberfläche der Scheibe bedeutet hierbei die Oberfläche der Scheibe, die nach außen, also von dem Fahrzeuginnenraum weg weißt. Innenseitige Oberfläche bedeutet demnach die Oberfläche der Scheibe, die zum Fahrzeuginnenraum hin weist.

Im Falle einer Fensterscheibe als Architekturscheibe oder als Bauverglasung, kann die Fensterscheibe beispielsweise eine Fassadenverglasung, eine Dachscheibe oder eine andere einen Wohnraum oder Gebäudeinnenraum begrenzende Verglasung sein. Außenseitige Oberfläche der Scheibe bedeutet hierbei die Oberfläche der Scheibe, die nach außen, also von dem Innenraum weg weist. Innenseitige Oberfläche bedeutet demnach die Oberfläche der Scheibe, die zum Innenraum hin weist.

Im Allgemeinen definiert sich die innenseitige Oberfläche dadurch, dass die Low-E-Beschichtung auf ihr angeordnet ist. Die außenseitige Oberfläche ist dann die zur innenseitigen Oberfläche gegenüberliegende Oberfläche der Scheibe.

Eine erfindungsgemäße Low-E-Beschichtung enthält mindestens eine funktionelle Schicht und optional jeweils eine oder mehrere Haftschichten, Barriereschichten und/oder Antireflexionsschichten. Die Low-E-Beschichtung ist bevorzugt ein Schichtsystem aus jeweils mindestens einer Haftschicht, einer funktionellen Schicht, einer Barriereschicht, einer Antireflexionsschicht und einer weiteren Barriereschicht. Besonders geeignete Low-E-Beschichtungen enthalten eine funktionelle Schicht aus mindestens einem elektrisch leitfähigen Oxid (TCO), bevorzugt Indium-Zinnoxid (ITO), fluor-dotiertes Zinnoxid (SnO₂:F), antimon-dotiertes Zinnoxid (SnO₂:Sb), aluminiumdotiertes Zinkoxid (ZnO:Al) und/oder galliumdortiertes Zinkoxid (ZnO:Ga).

Besonders vorteilhafte erfindungsgemäße Low-E-Beschichtungen haben eine innenraumseitige Emissivität der erfindungsgemäßen Fensterscheibe von kleiner oder gleich 60%, bevorzugt kleiner oder gleich 45%, besonders bevorzugt kleiner oder gleich 30% und insbesondere kleiner oder gleich 20%. Mit innenraumseitiger Emissivität wird dabei das Maß bezeichnet, welches angibt, wieviel Wärmestrahlung die Scheibe in Einbaulage im Vergleich zu einem idealen Wärmestrahler (einem schwarzen Körper) in einen Innenraum, beispielsweise eines Gebäudes oder eines Fahrzeugs abgibt. Unter Emissivität wird im Sinne der Erfindung der normale Gesamtemissionsgrad bei 283 K nach der Norm EN 12898 verstanden.

In einer vorteilhaften Ausgestaltung beträgt der Flächenwiderstand der erfindungsgemäßen Low-E-Beschichtung von 10 Ohm/Quadrat bis 200 Ohm/Quadrat und bevorzugt von 10 Ohm/Quadrat bis 100 Ohm/Quadrat, besonders bevorzugt von 15 Ohm/Quadrat bis 50 Ohm/Quadrat und insbesondere von 20 Ohm/Quadrat bis 35 Ohm/Quadrat.

Die Absorption der erfindungsgemäßen Low-E-Beschichtung im sichtbaren Spektralbereich beträgt bevorzugt von etwa 1% bis etwa 15 %, besonders bevorzugt von etwa 1 % bis etwa 7%. Die Absorption der Beschichtung kann dabei bestimmt werden, indem die Absorption einer beschichteten Scheibe gemessen wird und die Absorption der unbeschichteten Scheibe subtrahiert wird. Die erfindungsgemäße Scheibe weist bei Reflexion bevorzugt einen Farbwert a* von -15 bis +5 und einen Farbwert b* von -15 bis +5 auf, betrachtet von der mit der erfindungsgemäßen Low-E-Beschichtung versehenen Seite aus. Die Angaben a* und b* beziehen sich auf die Farbkoordinaten gemäß dem kolorimetrischen Modell (L*a*b*-Farbraum).

Eine vorteilhafte erfindungsgemäße Low-E-Beschichtung weist im sichtbaren Spektralbereich eine geringe Absorption und eine geringe Reflexion und daher eine hohe Transmission auf. Die Low-E-Beschichtung kann daher auch auf Scheiben verwendet werden, bei denen eine deutliche Verringerung der Transmission nicht gewünscht, beispielsweise bei Fensterscheiben in Gebäuden, oder gesetzlich verboten ist, beispielsweise bei Windschutzscheiben oder vorderen Seitenscheiben in Kraftfahrzeugen.

Die erfindungsgemäße Low-E-Beschichtung ist zudem korrosionsbeständig. Die Low-E-Beschichtung kann daher auf der Oberfläche der Scheibe aufgebracht sein, die dafür vorgesehen ist, in Einbaulage der Scheibe einem Innenraum, beispielsweise eines Fahrzeugs oder eines Gebäudes, zugewandt zu sein. Auf dieser Oberfläche verringert die Low-E-Beschichtung besonders effektiv im Sommer die Aussendung von Wärmestrahlung der Scheibe in den Innenraum und im Winter die Abstrahlung von Wärme in die äußere Umgebung.

Derartige Low-E-Beschichtungen sind besonders dazu geeignet, bei Dachverglasungen dem Fahrzeughalter so viel thermischen Komfort zu bieten, dass auf die Verwendung und sogar den Einbau eines Sonnenschutz-Rollos verzichtet werden kann.

Um die angegebenen bevorzugten Werte für die Emissivität, den Flächenwiderstand, die Absorption und die Farbwerte in Reflexion zu erreichen, kann die Scheibe nach dem Aufbringen der Wärmestrahlung reflektierenden Beschichtung einer Temperaturbehandlung unterzogen werden. Die Scheibe wird dabei bevorzugt auf eine Temperatur von mindestens 200°C, besonders bevorzugt mindestens 300°C erhitzt. Eine solche Temperaturbehandlung beeinflusst insbesondere die Kristallinität der funktionellen Schicht und führt zu einer verbesserten Transmission der erfindungsgemäßen Beschichtung. Die Temperaturbehandlung verringert außerdem den Flächenwiderstand der Beschichtung, was zu einer verringerten Emissivität führt.

Es hat sich gezeigt, dass die Temperaturbehandlung aufgrund der Diffusion von Sauerstoff zu einer Oxidation der funktionellen Schicht führt. Durch die Barriereschicht kann das Ausmaß der Oxidation der funktionellen Schicht beeinflusst werden. Der Bereich für die Dicke der Barriereschicht von 10 nm bis 40 nm ist besonders vorteilhaft im Hinblick auf die Transmission von sichtbarem Licht, den Flächenwiderstand und insbesondere die Biegbarkeit der Low-E-Beschichtung. Eine dünnere Barriereschicht kann zu einem zu hohen Sauerstoffgehalt der funktionellen Schicht nach der Temperaturbehandlung führen. Eine dickere Barriereschicht kann zu einem zu geringen Sauerstoffgehalt der funktionellen Schicht nach der Temperaturbehandlung führen. Die Dicke der Barriereschicht beträgt bevorzugt von 10 nm bis 30 nm, besonders bevorzugt 12 nm bis 30 nm, ganz besonders bevorzugt von 15 nm bis 25 nm und insbesondere von 18 nm bis 22 nm. Damit werden besonders gute Ergebnisse im Hinblick auf die Transmission von sichtbarem Licht, den Flächenwiderstand und die Biegbarkeit erreicht. Die Dicke der Barriereschicht kann aber auch beispielsweise von 10 nm bis 18 nm oder von 12 nm bis 18 nm betragen.

Die Barriereschicht beeinflusst außerdem die Korrosionsbeständigkeit der erfindungsgemäßen Beschichtung. Eine dünnere Barriereschicht führt zu einer stärkeren Korrosionsanfälligkeit der Beschichtung gegenüber einer feuchten Atmosphäre. Die Korrosion der Beschichtung führt insbesondere zu einem deutlichen Anstieg der Absorption von sichtbarem Licht durch die Beschichtung.

Die Barriereschicht beeinflusst zudem die optischen Eigenschaften der Wärmestrahlung reflektierenden Beschichtung, insbesondere den Farbeindruck bei Reflexion von Licht. Die Barriereschicht ist erfindungsgemäß dielektrisch. Der Brechungsindex des Materials der Barriereschicht beträgt bevorzugt größer oder gleich dem Brechungsindex des Materials der funktionellen Schicht. Der Brechungsindex des Materials der Barriereschicht beträgt besonders bevorzugt von 1,7 bis 2,3. Die angegebenen Werte für Brechungsindizes sind bei einer Wellenlänge von 550 nm gemessen.

Die Barriereschicht enthält bevorzugt zumindest ein Oxid und/oder ein Nitrid. Das Oxid und/oder Nitrid kann stöchiometrisch oder nicht-stöchiometrisch zusammengesetzt sein. Die Barriereschicht enthält besonders bevorzugt zumindest Siliziumnitrid (Si₃N₄). Das ist besonders vorteilhaft im Hinblick auf den Einfluss der Barriereschicht auf die Oxidation der funktionellen Schicht und auf die optischen Eigenschaften der Scheibe. Das Siliziumnitrid kann Dotierungen aufweisen, beispielsweise Titan, Zirkonium, Bor, Hafnium und/oder Aluminium. Das Siliziumnitrid ist ganz besonders bevorzugt mit Aluminium dotiert (Si₃N₄:Al) oder mit Zirkonium dotiert (Si₃N₄:Zr) oder mit Bor dotiert (Si₃N₄:B). Das ist besonders vorteilhaft im Hinblick auf die optischen Eigenschaften, die Biegbarkeit, die Glätte und die Emissivität der Beschichtung sowie die Geschwindigkeit des Aufbringens der Barriereschicht beispielsweise durch Kathodenzerstäubung.

Das Siliziumnitrid wird bevorzugt mittels magnetfeldunterstützter Kathodenzerstäubung abgeschieden mit einem Target, das zumindest Silizium enthält. Das Target zur Abscheidung einer Barriereschicht enthaltend Aluminium-dotiertes Siliziumnitrid enthält bevorzugt von 80 Gew. % bis 95 Gew. % Silizium und von 5 Gew. % bis 20 Gew. % Aluminium sowie herstellungsbedingte Beimengungen. Das Target zur Abscheidung einer Barriereschicht enthaltend Bor-dotiertes Siliziumnitrid enthält bevorzugt von 99,9990 Gew. % bis 99,9999 Gew. % Silizium und von 0,0001 Gew. % bis 0,001 Gew. % Bor sowie herstellungsbedingte Beimengungen. Das Target zur Abscheidung einer Barriereschicht enthaltend Zirkonium-dotiertes Siliziumnitrid enthält bevorzugt von 60 Gew. % bis 90 Gew. % Silizium und von 10 Gew. % bis 40 Gew. % Zirkonium sowie herstellungsbedingte Beimengungen. Die Abscheidung des Siliziumnitrids erfolgt bevorzugt unter Zugabe von Stickstoff als Reaktionsgas während der Kathodenzerstäubung.

Bei einer Temperaturbehandlung nach dem Aufbringen der erfindungsgemäßen Low-E-Beschichtung kann das Siliziumnitrid teilweise oxidiert werden. Eine als Si₃N₄ abgeschiedene Barriereschicht enthält dann nach der Temperaturbehandlung SiₓN_{y}O_{z}, wobei der Sauerstoffgehalt typischerweise von 0 Atom-% bis 35 Atom-% beträgt.

Die Barriereschicht kann alternativ aber auch beispielsweise zumindest WO₃, Nb₂O₅, Bi₂O₃, TiO₂, Zr₃N₄ und/oder AIN enthalten.

Die Haftschicht führt zu einer dauerhaft stabilen Haftung der oberhalb der Haftschicht abgeschiedenen Schichten auf der Scheibe. Die Haftschicht verhindert weiter die Anreicherung von aus der Scheibe diffundierenden Ionen im Grenzbereich zur funktionellen Schicht, insbesondere von Natriumionen, falls die Scheibe aus Glas besteht. Solche Ionen können zur Korrosion und zu einer geringen Haftung der funktionellen Schicht führen. Die Haftschicht ist daher besonders vorteilhaft im Hinblick auf die Stabilität der funktionellen Schicht.

Das Material der Haftschicht weist bevorzugt einen Brechungsindex im Bereich des Brechungsindexes der Scheibe auf. Das Material der Haftschicht weist bevorzugt einen geringeren Brechungsindex als das Material der funktionellen Schicht auf. Die Haftschicht enthält bevorzugt zumindest ein Oxid. Die Haftschicht enthält besonders bevorzugt Siliziumdioxid (SiO₂). Das ist besonders vorteilhaft im Hinblick auf die Haftung der oberhalb der Haftungsschicht abgeschiedenen Schichten auf der Scheibe. Das Siliziumdioxid kann Dotierungen aufweisen, beispielsweise Fluor, Kohlenstoff, Stickstoff, Bor, Phosphor und/oder Aluminium. Das Siliziumdioxid ist ganz besonders bevorzugt mit Aluminium dotiert (SiO₂:Al), mit Bor dotiert (SiO₂:B) oder mit Zirkonium dotiert (SiO₂:Zr). Das ist besonders vorteilhaft im Hinblick auf die optischen Eigenschaften der Beschichtung sowie die Geschwindigkeit des Aufbringens der Haftschicht beispielsweise durch Kathodenzerstäubung.

Das Siliziumdioxid wird bevorzugt mittels magnetfeldunterstützter Kathodenzerstäubung mit einem Target abgeschieden, welches zumindest Silizium enthält. Das Target zur Abscheidung einer Haftschicht enthaltend Aluminium-dotiertes Siliziumdioxid enthält bevorzugt von 80 Gew. % bis 95 Gew. % Silizium und von 5 Gew. % bis 20 Gew. % Aluminium sowie herstellungsbedingte Beimengungen. Das Target zur Abscheidung einer Haftschicht enthaltend Bor-dotiertes Siliziumdioxid enthält bevorzugt von 99,9990 Gew. % bis 99,9999 Gew. % Silizium und von 0,0001 Gew. % bis 0,001 Gew. % Bor sowie herstellungsbedingte Beimengungen. Das Target zur Abscheidung einer Haftschicht enthaltend Zirkonium-dotiertes Siliziumdioxid enthält bevorzugt von 60 Gew. % bis 90 Gew. % Silizium und von 10 Gew. % bis 40 Gew. % Zirkonium sowie herstellungsbedingte Beimengungen. Die Abscheidung des Siliziumdioxids erfolgt bevorzugt unter Zugabe von Sauerstoff als Reaktionsgas während der Kathodenzerstäubung.

Die Dotierung der Haftschicht kann auch die Glätte der oberhalb der Haftschicht aufgebrachten Schichten verbessern. Eine hohe Glätte der Schichten ist besonders günstig bei Verwendung der erfindungsgemäßen Scheibe im Kraftfahrzeugbereich, da hierdurch eine unangenehme raue Haptik der Scheiben vermieden wird. Ist die erfindungsgemäße Scheibe eine Seitenscheibe, so kann sie mit geringer Reibung zu den Dichtlippen bewegt werden.

Die Haftschicht kann aber auch andere Materialen enthalten, beispielsweise andere Oxide wie TiO₂, Al₂O₃, Ta₂O₅, Y₂O₃, ZnO und/oder ZnSnOₓ oder Nitride wie AIN.

Die Haftschicht weist bevorzugt eine Dicke von 10 nm bis 150 nm auf, besonders bevorzugt von 15 nm bis 50 nm, beispielsweise etwa 30 nm. Das ist besonders vorteilhaft im Hinblick auf die Haftung der erfindungsgemäßen Beschichtung und die Vermeidung der Diffusion von Ionen von der Scheibe in die funktionelle Schicht.

Unterhalb der Haftschicht kann auch eine zusätzliche haftvermittelnde Schicht angeordnet sein, bevorzugt mit einer Dicke von 2 nm bis 15 nm. Beispielsweise kann die Haftschicht SiO₂ enthalten und die zusätzliche haftvermittelnde Schicht kann zumindest ein Oxid wie TiO₂, Al₂O₃, Ta₂O₅, Y₂O₃, ZnO und/oder ZnSnOₓ, oder ein Nitrid wie AIN enthalten. Durch die haftvermittelnde Schicht wird die Haftung der erfindungsgemäßen Beschichtung vorteilhaft weiter verbessert. Außerdem ermöglicht die haftvermittelnde Schicht eine verbesserte Anpassung der Farbwerte und der Transmission bzw. Reflexion.

Die funktionelle Schicht weist reflektierende Eigenschaften gegenüber Wärmestrahlung, insbesondere Infrarotstrahlung auf, ist im sichtbaren Spektralbereich jedoch weitgehend transparent. Die funktionelle Schicht enthält erfindungsgemäß zumindest ein transparentes, elektrisch leitfähiges Oxid (TCO). Der Brechungsindex des Materials der funktionellen Schicht beträgt bevorzugt von 1,7 bis 2,5. Die funktionelle Schicht enthält bevorzugt zumindest Indium-Zinn-Oxid (ITO). Damit werden besonders gute Ergebnisse hinsichtlich der Emissivität und der Biegbarkeit der erfindungsgemäßen Beschichtung erreicht.

Das Indium-Zinn-Oxid wird bevorzugt mittels magnetfeldunterstützter Kathodenzerstäubung mit einem Target aus Indium-Zinn-Oxid abgeschieden. Das Target enthält bevorzugt von 75 Gew. % bis 95 Gew. % Indiumoxid und von 5 Gew. % bis 25 Gew. % Zinnoxid sowie herstellungsbedingte Beimengungen. Die Abscheidung des Indium-Zinn-Oxids erfolgt bevorzugt unter einer Schutzgasatmosphäre, beispielsweise Argon. Dem Schutzgas kann auch ein geringer Anteil an Sauerstoff zugesetzt werden, beispielsweise um die Homogenität der funktionellen Schicht zu verbessern.

Das Target kann alternativ bevorzugt zumindest von 75 Gew. % bis 95 Gew. % Indium und von 5 Gew. % bis 25 Gew. % Zinn enthalten. Die Abscheidung des Indium-Zinn-Oxids erfolgt dann bevorzugt unter Zugabe von Sauerstoff als Reaktionsgas während der Kathodenzerstäubung.

Die Emissivität der erfindungsgemäßen Scheibe kann durch die Dicke der funktionellen Schicht beeinflusst werden. Die Dicke der funktionellen Schicht beträgt bevorzugt von 40 nm bis 200 nm, besonders bevorzugt von 90 nm bis 150 nm und ganz besonders bevorzugt von 100 nm bis 130 nm, beispielsweise etwa 120 nm. In diesem Bereich für die Dicke der funktionellen Schicht werden besonders vorteilhafte Werte für die Emissivität und eine besonders vorteilhafte Fähigkeit der funktionellen Schicht, eine mechanische Transformation wie Biegen oder Vorspannen ohne Beschädigung zu überstehen, erreicht.

Die funktionelle Schicht kann aber auch andere transparente, elektrisch leitfähige Oxide enthalten, beispielsweise Fluor-dotiertes Zinnoxid (SnO₂:F), Antimon-dotiertes Zinnoxid (SnO₂:Sb), Indium-Zink-Mischoxid (IZO), Gallium-dotiertes oder Aluminium-dotiertes Zinkoxid, Niobium-dotiertes Titanoxid, Cadmiumstannat und/oder Zinkstannat.

Die Antireflexionsschicht vermindert Reflexionen im sichtbaren Spektralbereich an der erfindungsgemäßen Fensterscheibe. Durch die Antireflexionsschicht wird insbesondere eine hohe Transmission im sichtbaren Spektralbereich durch die erfindungsgemäße Fensterscheibe erreicht sowie ein neutralerer Farbeindruck von reflektiertem und transmittiertem Licht. Die Antireflexionsschicht verbessert zudem die Korrosionsbeständigkeit der funktionellen Schicht. Das Material der Antireflexionsschicht weist bevorzugt einen Brechungsindex auf, der kleiner als der Brechungsindex des Materials der funktionellen Schicht ist. Der Brechungsindex des Materials der Antireflexionsschicht beträgt bevorzugt kleiner oder gleich 1,8.

Die Antireflexionsschicht enthält bevorzugt zumindest ein Oxid. Die Antireflexionsschicht enthält besonders bevorzugt Siliziumdioxid (SiO₂). Das ist besonders vorteilhaft im Hinblick auf die optischen Eigenschaften der Scheibe und die Korrosionsbeständigkeit der funktionellen Schicht. Das Siliziumdioxid kann Dotierungen aufweisen, beispielsweise Fluor, Kohlenstoff, Stickstoff, Bor, Phosphor und/oder Aluminium. Das Siliziumnitrid ist ganz besonders bevorzugt mit Aluminium dotiert (SiO₂:Al), mit Bor dotiert (SiO₂:B) oder mit Zirkonium dotiert (SiO₂:Zr).

Die Antireflexionsschicht kann aber auch andere Materialen enthalten, beispielsweise andere Oxide wie TiO₂, Al₂O₃, Ta₂O₅, Y₂O₃, ZnO und/oder ZnSnO, oder Nitride wie AIN.

Die Antireflexionsschicht weist bevorzugt eine Dicke von 20 nm bis 150 nm auf, besonders bevorzugt von 40 nm bis 100 nm. Das ist besonders vorteilhaft im Hinblick auf eine geringe Reflexion und eine hohe Transmission von sichtbarem Licht sowie die Einstellung eines gezielten Farbeindrucks der Scheibe und die Korrosionsbeständigkeit der funktionellen Schicht.

In einer vorteilhaften Ausgestaltung der Erfindung ist oberhalb der Wärmestrahlung reflektierenden Beschichtung eine Abdeckschicht angeordnet. Die Abdeckschicht schützt die erfindungsgemäße Beschichtung vor Beschädigungen, insbesondere vor Verkratzen. Die Abdeckschicht enthält bevorzugt zumindest ein Oxid, besonders bevorzugt zumindest Titanoxid (TiOₓ), ZrO₂, HfO₂, Nb₂O₅, Ta₂O₅, Cr₂O₃, WO₃ und/oder CeO₂. Die Dicke der Abdeckschicht beträgt bevorzugt von 2 nm bis 50 nm, besonders bevorzugt von 5 nm bis 20 nm. Damit werden besonders gute Ergebnisse hinsichtlich der Kratzfestigkeit erzielt.

Beispielhafte Schichtsysteme die als Low-E-Beschichtung geeignet sind sowie Verfahren zu deren Herstellung, sind beispielsweise aus der WO 2013/131667 A1 bekannt.

In der Scheibe bzw. Fensterscheibe der erfindungsgemäßen Scheibenanordnung ist mindestens ein kapazitiver Schaltbereich durch mindestens eine beschichtungsfreie erste Trennlinie aus der Low-E-Beschichtung elektrisch abgetrennt. Die erste Trennlinie ist in der Low-E-Beschichtung ausgebildet bzw. in die Low-E-Beschichtung eingeformt. Das bedeutet, dass die durch die erste Trennlinie abgetrennten Bereiche voneinander elektrisch isoliert sind. Die durch die erste Trennlinie abgetrennten Bereiche sind vorteilhafterweise galvanisch voneinander isoliert. Galvanisch voneinander isoliert bedeutet, dass kein Gleichstrom (DC) zwischen den Bereichen fließen kann.

Der kapazitive Schaltbereich weist einen Berührungsbereich, einen Zuleitungsbereich und einen Anschlussbereich auf, wobei der Zuleitungsbereich den Berührungsbereich mit dem Anschlussbereich elektrisch verbindet und der Anschlussbereich mit einer Sensorelektronik elektrisch verbindbar ist.

In einer vorteilhaften Ausgestaltung der Erfindung beträgt das Verhältnis von Breite b_{Z} zu Länge I_{Z} des Zuleitungsbereichs kleiner oder gleich 1:700 und bevorzugt von 1:3 bis 1:100. Weist der Zuleitungsbereich keine konstante Breite b_{Z} auf, beispielsweise wenn er trapezförmig oder tropfenförmig ausgebildet ist, so wird im Rahmen der vorliegenden Erfindung unter der Breite b_{Z} die gemittelte Breite des Zuleitungsbereichs verstanden.

Die Länge I_{Z} des Zuleitungsbereichs beträgt bevorzugt von 1 cm bis 70 cm, bevorzugt von 1 cm bis 12 cm und insbesondere von 3 cm bis 8 cm. Die Breite b_{Z} des Zuleitungsbereichs beträgt bevorzugt von 0,5 mm bis 10 mm und besonders bevorzugt von 0,5 mm bis 2 mm. Die Form des Zuleitungsbereichs ist bevorzugt rechteckförmig, streifenförmig oder linienförmig. Der Zuleitungsbereich kann geradlinig, aber auch gebogen, abgewinkelt, L-förmig, U-förmig oder beliebig krummlinig ausgebildet sein. Der Zuleitungsbereich lässt dabei einfach an die jeweiligen Gegebenheiten der Scheibe, wie von der Low-E-Beschichtung freien Zonen, anpassen und beispielsweise an diesen vorbei führen.

In einer vorteilhaften Ausgestaltung des Schaltbereichs hat der Berührungsbereich eine Fläche von 1 cm² bis 200 cm², besonders bevorzugt von 1 cm² bis 9 cm². Die Länge I_{B} des Berührungsbereichs beträgt bevorzugt von 1 cm bis 14 cm und besonders bevorzugt von 1 cm bis 3 cm. Die maximale Breite b_{B} des Berührungsbereichs beträgt bevorzugt von 1 cm bis 14 cm und besonders bevorzugt von 1 cm bis 3 cm. Der Berührungsbereich kann prinzipiell jede beliebige Form aufweisen. Besonders geeignete Berührungsbereiche sind kreisförmig, elliptisch oder tropfenförmig ausgebildet. Alternativ sind eckige Formen möglich, beispielsweise Dreiecke, Quadrate, Rechtecke, Trapeze oder anders geartete Vierecke oder Polygone höherer Ordnung. Allgemein ist es besonders vorteilhaft, wenn etwaige Ecken abgerundet sind. Dies gilt für alle Bereiche des Schaltbereichs insbesondere im Übergangsbereich zwischen Berührungsbereich und Zuleitungsbereich und/oder Zuleitungsbereich und Anschlussbereich. Besonders vorteilhaft ist es, wenn die Ecken einen Krümmungsradius von mindestens 3 mm, bevorzugt von mindestens 8 mm aufweisen.

In einer weiteren vorteilhaften Ausgestaltung des Schaltbereichs beträgt das Verhältnis der Breite b_{Z} des Zuleitungsbereichs zur maximalen Breite b_{B} des Berührungsbereichs von mindestens 1:2 und insbesondere von mindestens 1:10. Dadurch konnten besonders gute Schaltergebnisse erzielt werden.

In einer vorteilhaften Ausgestaltung der erfindungsgemäßen Scheibenanordnung, beträgt die Breite t₁ der Trennlinien von 30 µm bis 200 µm und bevorzugt von 70 µm bis 140 µm. Derartig dünne Trennlinien erlauben eine sichere und ausreichend hohe elektrische Isolierung und stören gleichzeitig die Durchsicht durch die Verbundscheibe nicht oder nur geringfügig.

Der Schaltbereich ist ein kapazitiver Schaltbereich, das heißt er ist besonders für eine kapazitive Berührungsdetektion oder Annäherungsdetektion ausgebildet. In einer vorteilhaften Ausgestaltung bildet der Schaltbereich dabei eine Flächenelektrode aus. Über eine externe kapazitive Sensorelektronik wird die Kapazität der Flächenelektrode gemessen. Die Kapazität der Flächenelektrode ändert sich gegen Erde, wenn ein geeigneter Körper (vorzugsweise ein menschlicher Körper), in ihre Nähe kommt oder beispielsweise die Low-E-Beschichtung im Bereich der Flächenelektrode berührt. Die Kapazitätsänderung wird durch die Sensorelektronik gemessen und bei Überschreiten eines Schwellwerts wird ein Schaltsignal ausgelöst. Der Schaltbereich wird durch Form und Größe der Flächenelektrode festgelegt.

Der Bereich der elektrisch leitfähigen Schicht, der außerhalb des kapazitiven Schaltbereichs angeordnet ist, ist über den zweiten Anschlussbereich mit der Sensorelektronik verbunden. Der Umgebungsbereich umfasst nicht die gesamte Low-E-Beschichtung außerhalb des kapazitiven Schaltbereichs, sondern ist durch mindestens eine zweite Trennlinie von der Low-E-Beschichtung abgetrennt und vom kapazitiven Schaltbereich und der den Umgebungsbereich umgebenden Teil der Low-E-Beschichtung bzw. Außenbereich elektrisch abgetrennt. Die zweite Trennlinie umgibt den kapazitiven Schaltbereich zumindest teilweise, insbesondere vollständig. Die zweite Trennlinie, die den Umgebungsbereich zumindest teilweise umrandet und den Umgebungsbereich von der restlichen umliegend angeordneten Low-E-Beschichtung abtrennt (d.h. Außenbereich), hat bevorzugt einen kürzesten Abstand von 0,1 mm bis 200 cm, besonders bevorzugt von 0,5 mm bis 100 mm und insbesondere einen kürzesten Abstand von 1 mm bis 11 mm von der benachbarten ersten Trennlinie. Der kürzeste Abstand entspricht somit der Breite u des Umgebungsbereichs. Der Umgebungsbereich umrandet zumindest teilweise alle kapazitiven Schaltbereiche (falls sie sich bis zum Rand der Low-E-Beschichtung erstrecken) bzw. vollständig (falls sie sich nicht bis zum Rand der Low-E-Beschichtung erstrecken).

In einer solchen Anordnung bilden der kapazitive Schaltbereich und der Umgebungsbereich zwei Elektroden aus, die kapazitiv miteinander gekoppelt sind. Die Kapazität des von den Elektroden gebildeten Kondensators ändert sich bei Annäherung eines geeigneten Körpers, vorzugsweise eines menschlichen Körperteils. Die Kapazitätsänderung wird durch eine Sensorelektronik gemessen und bei Überschreiten eines Schwellwerts wird ein Schaltsignal ausgelöst. Der sensitive Bereich wird durch Form und Größe des Bereichs, in denen die Elektroden kapazitiv gekoppelt sind, festgelegt. Hierdurch kann eine besonders gute Signalqualität erreicht werden.

Der erfindungsgemäße kapazitive Schaltbereich und der Umgebungsbereich sind in die erfindungsgemäße Scheibe bzw. Fensterscheibe integriert. Es ist also kein Schalter oder ähnliches als separates Bauteil nötig, welches an der Fensterscheibe angebracht werden muss. Die Fensterscheibe weist bevorzugt auch keine sonstigen Bauteile auf, die im Durchsichtbereich auf ihren Oberflächen angeordnet sind. Das ist besonders vorteilhaft im Hinblick auf eine dünne Bauweise der Fensterscheibe sowie einer nur geringen Störung der Durchsicht durch die Fensterscheibe.

Eine Ausgestaltung der Erfindung umfasst eine Verbundscheibe mit kapazitivem Schaltbereich und Low-E-Beschichtung, mindestens umfassend:
- eine Innenscheibe, die aus der Scheibe der erfindungsgemäßen Scheibenanordnung mit kapazitiven Schaltbereich und Low-E-Beschichtung besteht,
- eine Außenscheibe mit einer innenseitigen Oberfläche (II) und
- mindestens einer Zwischenschicht, die die innenseitige Oberfläche (II) der Außenscheibe flächig mit einer außenseitigen Oberfläche (III) der Innenscheibe verbindet.

Die innenseitige Oberfläche der Verbundscheibe entspricht somit der innenseitigen Oberfläche der Innenscheibe und die außenseitige Oberfläche der Verbundscheibe entspricht der außenseitigen Oberfläche der Außenscheibe.

Im Falle einer Verbundscheibe werden die Innenscheibe und die Außenscheibe durch mindestens eine Zwischenschicht miteinander verbunden. Die Zwischenschicht ist bevorzugt transparent. Die Zwischenschicht enthält vorzugsweise mindestens einen Kunststoff, bevorzugt Polyvinylbutyral (PVB), Ethylenvinylacetat (EVA) und/oder Polyethylenterephthalat (PET). Die Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die Zwischenschicht kann durch eine oder mehrere übereinander angeordnete Folien ausgebildet werden, wobei die Dicke einer Folie bevorzugt von 0,025 mm bis 1 mm beträgt, typischerweise 0,38 mm oder 0,76 mm. Die Zwischenschichten können bevorzugt thermoplastisch sein und nach der Lamination die Innenscheibe, die Außenscheibe und eventuelle weitere Zwischenschichten miteinander verkleben.

Die Zwischenschicht hat bevorzugt eine relative Permittivität von 2 bis 4 und besonders bevorzugt von 2,1 bis 2,9. Bei derartigen relativen Permittivitäten konnte eine besonders gute Unterscheidung zwischen einer Berührung der Berührungsfläche über die außenseitige Oberfläche der Verbundscheibe von der gegenüberliegenden innenseitigen Oberfläche erzielt werden.

Die Erfindung umfasst somit eine Scheibenanordnung mit einer erfindungsgemäßen Fensterscheibe oder einer erfindungsgemäßen Verbundscheibe und einer Sensorelektronik, die über einen ersten Anschlussbereich mit dem kapazitiven Schaltbereich und über einen zweiten Anschlussbereich mit der Umgebungsfläche elektrisch verbunden ist. Die Sensorelektronik ist eine kapazitive Sensorelektronik.

In einer vorteilhaften Ausgestaltung der erfindungsgemäßen Schaltanordnung ist die Empfindlichkeit der Sensorelektronik so gewählt, dass die Sensorelektronik bei Berührung des Berührungsbereichs mit einem menschlichen Finger auf der innenseitigen Oberfläche der Scheibe bzw. der Verbundscheibe ein Schaltsignal ausgibt und bei Berührung des Berührungsbereichs auf der außenseitigen Oberfläche der Scheibe oder der Außenscheibe kein Schaltsignal oder ein anderes Schaltsignal ausgibt. Es versteht sich, dass die Berührung des Berührungsbereichs auch mit mehreren Fingern oder einem anderen menschlichen Körperteil erfolgen kann. Unter Berührung wird im Rahmen dieser Erfindung jegliche Wechselwirkung mit dem Schaltbereich verstanden, die zu einer messbaren Änderung des Messsignals, also hier der Kapazität, führt. Insbesondere ist dies eine Berührung einer außenseitigen Oberfläche der Fensterscheibe oder der Verbundscheibe in einer Zone, die sich durch orthogonale Projektion des Berührungsbereichs auf der außenseitigen Oberfläche ergibt.

Bei geeigneter Wahl der Empfindlichkeit der Sensorelektronik und geeigneter Dimensionierung des kapazitiven Schaltbereichs kann bereits die Annäherung an den Berührungsbereich zum Auslösen eines Schaltsignals genügen. Die erfindungsgemäße Scheibenanordnung, bei der die Low-E-Beschichtung auf der innenseitigen Oberfläche IV der Scheibe bzw. Innenscheibe angeordnet ist, weist eine besonders vorteilhafte hohe Asymmetrie im Schaltverhalten auf. Das heißt, die Sensitivität ist bei Annäherung oder Berührung der innenseitigen Oberfläche IV (mit der unmittelbaren Low-E-Beschichtung) höher als bei Annäherung oder Berührung der außenseitigen Oberfläche (III oder I), bei der noch die Scheibe bzw. Innenscheibe, Zwischenschicht und Außenscheibe zwischen dem menschlichen Körper und der Low-E-Beschichtung mit kapazitivem Schaltbereich angeordnet ist.

Es versteht sich, dass die Empfindlichkeit der Sensorelektronik auch derart gewählt werden kann, dass ein Schaltvorgang bei Berührung oder Annäherung von beiden Seiten der Oberflächen ausgelöst wird.

Unter Annäherung sei im Rahmen der Erfindung eine Annäherung durch einen menschlichen Körper von weniger oder gleich 20 cm, bevorzugt weniger oder gleich 10 cm und insbesondere weniger oder gleich 5 cm zu verstehen, ohne dass eine direkte Berührung stattfindet.

Die ausgegebenen Schaltsignale können beliebig und den Erfordernissen der jeweiligen Verwendung angepasst sein. So kann das Schaltsignal eine positive Spannung, beispielsweise 12 V, bedeuten, kein Schaltsignal beispielsweise 0 V bedeuten und ein anderes Schaltsignal beispielweise + 6 V bedeuten. Die Schaltsignale können auch den bei einem CAN-Bus üblichen Spannungen CAN_High und CAN_Low entsprechen und um einen dazwischen liegenden Spannungswert wechseln. Das Schaltsignal kann auch gepulst und/oder digital codiert sein.

Die Empfindlichkeit der Sensorelektronik kann in Abhängigkeit der Größe des Berührungsbereichs und in Abhängigkeit der Dicke von Scheibe bzw. Innenscheibe, Zwischenschicht(en) und Außenscheibe im Rahmen einfacher Experimente ermittelt werden.

Der besondere Vorteil einer solchen erfindungsgemäßen Scheibenanordnung liegt darin, dass das Schaltsignal nur bei Annäherung an oder Berührung der Fensterscheibe bzw. der Verbundscheibe von einer der innenseitigen Oberflächen ausgelöst werden kann. Bei einer Verwendung der Scheibenanordnung in einer Fahrzeugscheibe und Einbau der Fenster- oder Verbundscheibe mit der innenseitigen Oberfläche in Richtung des Fahrzeuginnenraums kann beispielsweise ein Auslösen des Schaltvorgangs durch Personen von außen oder ein ungewolltes Auslösen des Schaltvorgangs durch Regen oder die Bewegung des Scheibenwischers sicher vermieden werden, ohne den generell üblichen Scheibenaufbau grundlegend zu verändern. Dies war für den Fachmann unerwartet und überraschend.

In Kombination oder alternativ kann die Empfindlichkeit der Sensorelektronik so gewählt werden, dass sie bei Annäherung an den Berührungsbereich oder bei Berührung des Berührungsbereichs auf den Oberflächen der Fenster- oder Verbundscheibe mit einem menschlichen Finger ein Schaltsignal ausgibt und bei Berührung des Zuleitungsbereichs auf den Oberflächen der Fenster- oder Verbundscheibe kein Schaltsignal oder ein anderes Schaltsignal ausgibt.

Die Empfindlichkeit der Sensorelektronik kann in Abhängigkeit der Größe des Berührungsbereichs und in Abhängigkeit der Geometrie sowie des Aspektverhältnisses zwischen Breite und Länge des Zuleitungsbereichs im Rahmen einfacher Experimente ermittelt werden. Besonders vorteilhaft ist es dabei, wenn die Breite des Zuleitungsbereichs möglichst gering gewählt wird.

Der besondere Vorteil dieser Ausführungsform einer erfindungsgemäßen Scheibenanordnung liegt darin, dass das Schaltsignal nur bei Berührung der außenseitigen Oberfläche der Fenster- oder Verbundscheibe über dem Berührungsbereich oder seiner unmittelbaren Umgebung ausgelöst werden kann und so eine präzise Steuerung des Schaltvorgangs möglich ist und beispielsweise ein versehentliches Schalten vermieden wird.

In einer vorteilhaften Weiterbildung einer erfindungsgemäßen Scheibenanordnung ist der Anschlussbereich mit einem Flachleiter, einem metallischen Draht, insbesondere einem Rundleiter oder einem litzenförmigen Leiter verbunden und von der Scheibenoberfläche weggeführt. Die integrierte Scheibenanordnung kann dann besonders einfach am Verwendungsort mit einer Spannungsquelle und einer Signalleitung verbunden werden, die das Schaltsignal der Sensorschaltung auswertet, beispielsweise in einem Fahrzeug über einen CAN-Bus.

Als Scheibe bzw. Innenscheibe und Außenscheibe sind im Grunde alle elektrisch isolierenden Substrate geeignet, die unter den Bedingungen der Herstellung und der Verwendung der erfindungsgemäßen Fenster- oder Verbundscheibe thermisch und chemisch stabil sowie dimensionsstabil sind.

Die Scheibe bzw. die Innenscheibe und die Außenscheibe enthalten bevorzugt Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Die Scheibe bzw. die Innenscheibe und die Außenscheibe sind bevorzugt transparent, insbesondere für die Verwendung der Scheibe als Windschutzscheibe oder Rückscheibe eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich von größer 70 % aufweist. Für Scheiben, die nicht im verkehrsrelevanten Sichtfeld des Fahrers liegen, beispielsweise für Dachscheiben, kann die Transmission aber auch viel geringer sein, beispielsweise größer als 5 %.

Die Dicke von der Scheibe bzw. der Innenscheibe und der Außenscheibe kann breit variieren und so hervorragend den Erfordernissen des Einzelfalls angepasst werden. Vorzugsweise werden Standardstärken von 1,0 mm bis 25 mm, bevorzugt von 1,4 mm bis 2,5 mm für Fahrzeugglas und bevorzugt von 4 mm bis 25 mm für Möbel, Geräte und Gebäude, verwendet. Die Größe der Fenster- und der Verbundscheibe kann breit variieren und richtet sich nach der Größe der erfindungsgemäßen Verwendung.

Fenster- und Verbundscheibe weisen beispielsweise im Fahrzeugbau und Architekturbereich übliche Flächen von 200 cm² bis zu 20 m² auf.

Die Fenster- oder Verbundscheibe kann eine beliebige dreidimensionale Form aufweisen. Vorzugsweise hat die dreidimensionale Form keine Schattenzonen, so dass sie beispielsweise durch Kathodenzerstäubung beschichtet werden kann. Bevorzugt sind die Scheiben plan oder leicht oder stark in einer Richtung oder in mehreren Richtungen des Raumes gebogen. Insbesondere werden plane Scheiben verwendet. Die Scheiben können farblos oder gefärbt sein.

Die Scheibe bzw. Innenscheibe und die Außenscheibe weisen bevorzugt eine relative Permittivität ε_{r,1/4} von 2 bis 8 und besonders bevorzugt von 6 bis 8 auf. Bei derartigen relativen Permittivitäten konnte eine besonders gute Unterscheidung zwischen einer Berührung der Berührungsfläche über die außenseitige Oberfläche der Fenster- oder Verbundscheibe von der gegenüberliegenden innenseitigen Oberfläche erzielt werden.

In einer vorteilhaften Ausgestaltung der erfindungsgemäßen Fensterscheibe oder der erfindungsgemäßen Verbundscheibe ist der Anschlussbereich am äußeren Rand der Scheibe angeordnet. Dabei beträgt der Abstand zum äußeren Rand bevorzugt weniger als 10 cm, besonders bevorzugt weniger als 0,5 cm. Dies erlaubt es, eine elektrische Kontaktierung des Anschlussbereichs, beispielsweise mit einem Folienleiter, unter einem optisch unauffälligen Schwarzdruck oder mit einer Abdeckung, beispielsweise einem Kameragehäuse zu kaschieren.

Die elektrische Zuleitung ist bevorzugt als Folienleiter oder flexibler Folienleiter (Flachleiter, Flachbandleiter) ausgebildet. Unter Folienleiter wird ein elektrischer Leiter verstanden, dessen Breite deutlich größer ist als seine Dicke. Ein solcher Folienleiter ist beispielsweise ein Streifen oder Band enthaltend oder bestehend aus Kupfer, verzinntem Kupfer, Aluminium, Silber, Gold oder Legierungen davon. Der Folienleiter weist beispielsweise eine Breite von 2 mm bis 16 mm und eine Dicke von 0,03 mm bis 0,1 mm auf. Der Folienleiter kann eine isolierende, bevorzugt polymere Ummantelung, beispielsweise auf Polyimid-Basis aufweisen. Folienleiter, die sich zur Kontaktierung von elektrisch leitfähigen Beschichtungen in Scheiben eignen, weisen lediglich eine Gesamtdicke von beispielsweise 0,3 mm auf. Derart dünne Folienleiter können einfach und ästhetisch auf der innenseitigen Oberfläche IV angeordnet und beispielsweise aufgeklebt werden. In einem Folienleiterband können sich mehrere voneinander elektrisch isolierte, leitfähige Schichten befinden.

Alternativ können auch dünne Metalldrähte als elektrische Zuleitung verwendet werden. Die Metalldrähte enthalten insbesondere Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten. Die Metalldrähte können aus einem oder mehreren Einzeldrähten oder Litzen bestehen, die in ihrer Gesamtheit rund oder flach oder beliebig geformt angeordnet sind. Die Einzeldrähte oder Litzen können innerhalb mehradrigen Kabels voneinander elektrisch isoliert ausgebildet sein.

Die elektrische Leitungsverbindung zwischen dem Anschlussbereich und der elektrischen Zuleitung erfolgt bevorzugt über elektrisch leitfähige Kleber, die eine sichere und dauerhaft elektrische Leitungsverbindung zwischen Anschlussbereich und Zuleitung ermöglichen. Alternativ kann die elektrische Leitungsverbindung auch durch Klemmen erfolgen. Alternativ kann die Zuleitung auch auf den Anschlussbereich aufgedruckt werden, beispielsweise mittels einer eingebrannten metallhaltigen und insbesondere silberhaltigen, elektrisch leitfähigen Druckpaste.

In einer alternativen Ausgestaltung erfolgt die elektrische Leitungsverbindung zwischen dem Anschlussbereich und der elektrischen Zuleitung durch Löten, bevorzugt durch Ultraschall-Löten. Alternativ kann ein weiteres Anschlusselement zwischen Anschlussbereich und elektrischer Zuleitung angeordnet sein, beispielsweise ein Steckfuss, ein Crimp-Element oder eine Multipol-Anschluss. Die elektrische Zuleitung kann direkt mit dem Anschlusselement verbunden sein, oder über einen Stecker oder eine Kupplung mit diesem fest oder lösbar verbunden werden.

Ein geschlossenes Crimp-Element kann beispielsweise einen ovalen (Oval-Crimp) oder polygonalen (beispielsweise Vierkant-Crimp, Sechskant-Crimp oder Trapezcrimp) Querschnitt aufweisen. Eine der Wirkstellen des Crimpwerkzeugs kann auch eine charakteristische Quetschstruktur erzeugen, wobei der Quetschstruktur gegenüberliegend typischerweise der sogenannte Crimpboden angeordnet ist. Die Form der Crimpung wird typischerweise nach der charakteristischen Quetschstruktur benannt. Formen für einen geschlossenen Crimp sind dem Fachmann beispielsweise als W-Crimp oder Dorn-Crimp bekannt. Bei einem offenen Crimp-Element sind die beiden um das Anschlusskabel herumgebogenen Seitenkanten des Anschlusselements mit einer charakteristischen Quetschstruktur miteinander und mit dem Anschlusskabel verquetscht. Formen für einen offenen Crimp sind dem Fachmann beispielsweise als B-Crimp (oder F-Crimp), Ü-Crimp (oder OVL-Crimp) oder O-Crimp bekannt. Derartige Crimp-Elemente werden üblicherweise auf den Anschlussbereich gelötet oder mittels eines leitfähigen Klebers geklebt. Besonders vorteilhaft sind dabei Crimp-Elemente mit einem flachen Bereich, beispielsweise einem ebenen Crimp-Boden.

In einer vorteilhaften Ausgestaltung der Fensterscheibe oder Verbundscheibe ist der Berührungsbereich durch eine aktive Lichtquelle direkt markierbar oder markiert, bevorzugt durch eine Leuchtdiode (LED), eine organische Leuchtdiode (OLED), eine Glühbirne oder andere aktive Leuchtkörper, wie ein lumineszentes Material, bevorzugt ein fluoreszierende oder phosphoreszierendes Material.

In einer alternativen Ausgestaltung der Fensterscheibe oder Verbundscheibe ist der Berührungsbereich durch einen farbigen, bevorzugt einen weißen oder schwarzen, Aufdruck, beispielsweise einem Siebdruck, auf der Scheibe bzw. Innenscheibe, der Zwischenschicht oder der Deckscheibe, markiert. Dies hat den besonderen Vorteil, dass der Berührungsbereich unabhängig von einer Spannungsquelle und dauerhaft markiert ist. Der Aufdruck kann auch ein lumineszentes Material, bevorzugt ein fluoreszierendes oder phosphoreszierendes Material enthalten und/oder nachleuchtend sein.

In einer weiteren alternativen Ausgestaltung der Erfindung weist die Fenster- oder Verbundscheibe ein Lichteinstrahlmittel und ein Lichtablenkmittel auf. Lichteinstrahlmittel und Lichtablenkmittel sind dabei beispielsweise an der Fensterscheibe oder in oder an der Verbundscheibe angeordnet, bevorzugt zwischen Innenscheibe und Außenscheibe.

Das Lichteinstrahlmittel umfasst erfindungsgemäß zumindest eine Lichtquelle, bevorzugt eine LED oder OLED. Der besondere Vorteil liegt in den kleinen Abmessungen und der geringen Leistungsaufnahme. Der von der Lichtquelle emittierte Wellenlängenbereich kann im Bereich des sichtbaren Lichtes frei gewählt werden, beispielsweise nach praktischen und/oder ästhetischen Gesichtspunkten. Das Lichteinstrahlmittel kann optische Elemente umfassen, insbesondere zur Lenkung des Lichts, bevorzugt einen Reflektor und/oder einen Lichtwellenleiter, beispielsweise eine Glasfaser oder eine polymere optische Faser. Das Lichteinstrahlmittel kann an einer beliebigen Stelle der Scheibe bzw. der Innenscheibe oder Außenscheibes angeordnet sein, insbesondere am Seitenrand der Fensterscheibe oder Verbundscheibe oder in einer kleinen Ausnehmung inmitten von Innenscheibe und Außenscheibe.

Das Lichtablenkmittel umfasst bevorzugt Partikel, Punktraster, Aufkleber, Anlagerungen, Einkerbungen, Einritzungen, Strichraster, Aufdrucke und/oder Siebdrucke und ist dazu geeignet, das in der Scheibe bzw. Innenscheibe, Zwischenschicht oder Außenscheibe transportierte Licht aus demselben auszukoppeln.

Das Lichtablenkmittel kann an jeder beliebigen Position auf der Ebene der Scheibe bzw. Innenscheibe, Zwischenschicht oder Außenscheibe angeordnet sein. Besonders vorteilhaft ist es, wenn das Lichtablenkmittel im Bereich oder in unmittelbarer Umgebung des Berührungsbereichs angeordnet ist und so ein schnelles Auffinden des ansonsten kaum sichtbaren Berührungsbereichs ermöglicht. Dies ist insbesondere bei Nacht oder Dunkelheit besonders vorteilhaft.

Alternativ kann Licht durch einen Lichtleiter, der auf der Scheibe bzw. Innenscheibe, Zwischenschicht oder Außenscheibe angeordnet ist, an den Berührungsbereich herangeführt werden und diesen markieren.

Alternativ oder in Kombination kann das Lichteinstrahlmittel zusammen mit dem Lichtablenkmittel eine Information auf der Fensterscheibe oder der Verbundscheibe visualisieren, beispielsweise den Schaltzustand des kapazitiven Schaltbereichs wiedergeben oder anzeigen, ob beispielsweise eine elektrische Funktion eingeschaltet oder ausgeschaltet ist.

Ein weiterer Aspekt der Erfindung umfasst ein Verfahren zur Herstellung einer solchen Scheibenanordnung mit Fensterscheibe bzw. Scheibe mit kapazitivem Schaltbereich, mindestens umfassend:
Aufbringen einer Low-E-Beschichtung auf eine innenseitige Oberfläche (IV) der Scheibe,
Einbringen mindestens einer ersten Trennlinie in die Low-E-Beschichtung, durch die mindestens ein kapazitiver Schaltbereich von einem Umgebungsbereich der Low-E-Beschichtung elektrisch abgetrennt ist, wobei der Umgebungsbereich den kapazitiven Schaltbereich zumindest abschnittsweise, insbesondere vollständig, umgibt, bevorzugt durch Laserstrukturierung oder durch mechanisches oder chemisches Abtragen,
Einbringen mindestens einer zweiten Trennlinie in die Low-E-Beschichtung, durch die der Umgebungsbereich von einem Außenbereich der Low-E-Beschichtung elektrisch abgetrennt ist, wobei der Außenbereich den Umgebungsbereich zumindest teilweise, insbesondere vollständig umgibt, bevorzugt durch Laserstrukturierung oder durch mechanisches oder chemisches Abtragen.

Ist die Scheibe als Verbundscheibe ausgebildet, können die folgenden Schritte enthalten sein:
Aufbringen einer Low-E-Beschichtung auf eine innenseitige Oberfläche (IV) einer Innenscheibe und Einbringen mindestens einer ersten Trennlinie in die Low-E-Beschichtung, durch die mindestens ein kapazitiver Schaltbereich von einem Umgebungsbereich der Low-E-Beschichtung elektrisch abgetrennt ist, wobei der Umgebungsbereich den kapazitiven Schaltbereich zumindest abschnittsweise, insbesondere vollständig, umgibt, bevorzugt durch Laserstrukturierung oder durch mechanisches oder chemisches Abtragen, sowie Einbringen mindestens einer zweiten Trennlinie in die Low-E-Beschichtung, durch die der Umgebungsbereich von einem Außenbereich der Low-E-Beschichtung elektrisch abgetrennt ist, wobei der Außenbereich den Umgebungsbereich zumindest teilweise, insbesondere vollständig umgibt, bevorzugt durch Laserstrukturierung oder durch mechanisches oder chemisches Abtragen,
Herstellen einer Stapelfolge aus der Innenscheibe, einer Zwischenschicht und einer Außenscheibe, wobei die Zwischenschicht zwischen der innenseitigen Oberfläche (II) der Außenscheibe und der außenseitigen Oberfläche (III) der Innenscheibe angeordnet wird, und Laminieren der Stapelfolge zu einer Verbundscheibe.

Das heißt, es wird zuerst eine Scheibe der erfindungsgemäßen Scheibenanordnung hergestellt und diese in einem zweiten Schritt aus einer Stapelfolge von Innenscheibe (die aus der erfindungsgemäßen Fensterscheibe besteht), Zwischenschicht und Außenscheibe zu einer Verbundscheibe laminiert.

In einer alternativen Ausführungsform des erfindungsgemäßen Verfahrens zur Herstellung einer Scheibenanordnung mit Verbundscheibe mit kapazitivem Schaltbereich können die Verfahrensschritte auch vertauscht sein. Das heißt es wird zunächst ein Laminat aus der Stapelfolge aus Innenscheibe, Zwischenschicht und Außenscheibe gebildet und anschließend die Low-E-Beschichtung auf der innenseitigen Oberfläche der Innenscheibe abgeschieden und dieses strukturiert.

Das Aufbringen der Low-E-Beschichtung kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung der Scheiben. Die elektrisch leitfähigen Schicht kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Die Entschichtung einzelner Trennlinien in der Low-E-Beschichtung erfolgt vorzugsweise durch einen Laserstrahl. Verfahren zum Strukturieren dünner Metallfilme sind beispielsweise aus EP 2 200 097 A1 oder EP 2 139 049 A1 bekannt. Die Breite der Entschichtung beträgt bevorzugt 10 µm bis 1000 µm, besonders bevorzugt 30 µm bis 200 µm und insbesondere 70 µm bis 140 µm. In diesem Bereich findet eine besonders saubere und rückstandsfreie Entschichtung durch den Laserstrahl statt. Die Entschichtung mittels Laserstrahl ist besonders vorteilhaft, da die entschichteten Linien optisch sehr unauffällig sind und das Erscheinungsbild und die Durchsicht nur wenig beeinträchtigen. Die Entschichtung einer Linie mit einer Breite, die breiter ist als die Breite eines Laserschnitts, erfolgt durch mehrmaliges Abfahren der Linie mit dem Laserstrahl. Die Prozessdauer und die Prozesskosten steigen deshalb mit zunehmender Linienbreite an. Alternativ kann die Entschichtung durch mechanisches Abtragen sowie durch chemisches oder physikalisches Ätzen erfolgen.

Das Laminieren, also das Verbinden von Innenscheibe, Zwischenschicht und Außenscheibe erfolgt bevorzugt unter Einwirkung von Hitze, Vakuum und/oder Druck. Es können an sich bekannte Verfahren zur Herstellung einer Verbundscheibe verwendet werden.

So können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C.

Die Innenscheibe, die beispielsweise thermoplastische Zwischenschicht und die Außenscheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die Innenscheibe und die Außenscheibe innerhalb von beispielsweise etwa 60 Minuten bei verminderten Drücken von 0,01 mbar bis 800 mbar und Temperaturen von 80°C bis 170°C laminiert werden.

Als weiterer Verfahrensschritt kann die galvanische Kontaktierung der Low-E-Beschichtung durch eine elektrische Leitungsverbindung erfolgen. Die galvanische Kontaktierung erfolgt bevorzugt mittels Kleben mit einem elektrisch leitfähigen Klebstoff, Löten und insbesondere Ultraschall-Löten.

Beim galvanischen Kontaktieren kann es vorteilhaft sein, wenn zunächst eine elektrisch leitfähige Kontaktschicht auf die Low-E-Beschichtung aufgebracht wird, beispielsweise durch eine Metallisierung oder durch Drucken mittels einer metallhaltigen Siebdruckpaste und nachfolgendem Einbrennen. Diese Kontaktschicht ist besonders vorteilhaft um eine niederohmige und korrosionsstabile Kontaktierung zwischen den leitfähigen Bestandteilen der Low-E-Beschichtung und den weiteren Anschlusselementen wie Folienleiter oder Rundleiter zu erzielen.

Ein weiterer Aspekt der Erfindung umfasst die Verwendung der erfindungsgemäßen Scheibenanordnung mit Fensterscheibe oder Verbundscheibe mit kapazitivem Schaltbereich in Gebäuden, insbesondere im Zugangsbereich, Fensterbereich, Dachbereich oder Fassadenbereich, als Einbauteil in Möbeln und Geräten, in Fortbewegungsmitteln für den Verkehr auf dem Lande, in der Luft oder zu Wasser, insbesondere in Zügen, Schiffen und Kraftfahrzeugen beispielsweise als Windschutzscheibe, Heckscheibe, Seitenscheibe und/oder Dachscheibe.

Die Erfindung umfasst weiter die Verwendung des kapazitiven Schaltbereichs einer erfindungsgemäßen Scheibenanordnung mit Fensterscheibe oder Verbundscheibe zur elektrischen Steuerung einer Funktion innerhalb oder außerhalb der Fenster- oder Verbundscheibe, bevorzugt einer Heizfunktion, einer Beleuchtung, insbesondere eines an oder in der Fenster- oder Verbundscheibe angeordneten Leuchtmittels wie einer LED, einer Änderung der optischen Transparenz einer funktionellen Zwischenschicht, insbesondere einer Suspended Particle Device (SPD)-Schicht oder einer elektrochromen Zwischenschicht.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Figur 1A: eine Draufsicht auf eine Ausgestaltung einer erfindungsgemäßen Scheibenanordnung mit einer Fensterscheibe;
- Figur 1B: eine Querschnittsdarstellung entlang der Schnittlinie A-A' aus Figur 1A;
- Figur 1C: eine vergrößerte Darstellung des Ausschnitts Z aus Figur 1A;
- Figur 1D: eine Querschnittsdarstellung entlang der Schnittlinie B-B' aus Figur 1C;
- Figur 1E: eine vergrößerte Darstellung eines Ausschnitts Z nach Figur 1A einer alternativen Ausgestaltung der Fensterscheibe;
- Figur 1F: eine vergrößerte Darstellung eines Ausschnitts Z nach Figur 1A einer weiteren alternativen Ausgestaltung der Fensterscheibe;
- Figur 2A: eine Draufsicht auf eine alternative Ausgestaltung einer erfindungsgemäßen Scheibenanordnung mit einer Verbundscheibe;
- Figur 2B: eine Querschnittsdarstellung entlang der Schnittlinie A-A' aus Figur 2A;
- Figur 2C: eine vergrößerte Darstellung des Ausschnitts Z aus Figur 2A;
- Figur 2D: eine Querschnittsdarstellung entlang der Schnittlinie B-B' aus Figur 2C;
- Figur 2E: eine Querschnittsdarstellung entlang der Schnittlinie B-B' aus Figur 2C einer weiteren alternativen Ausgestaltung der Verbundscheibe;
- Figur 2F: eine Querschnittsdarstellung entlang der Schnittlinie B-B' aus Figur 2C einer weiteren alternativen Ausgestaltung der Verbundscheibe;
- Figur 3A: eine Draufsicht auf eine weitere alternative Ausgestaltung einer erfindungsgemäßen Scheibenanordnung mit einer Verbundscheibe am Beispiel einer Windschutzscheibe;
- Figur 3B: eine Querschnittsdarstellung entlang der Schnittlinie A-A' aus Figur 3A;
- Figur 4A: ein detailliertes Flussdiagramm einer Ausführungsform des erfindungsgemäßen Verfahrens zur Herstellung einer Fensterscheibe; und
- Figur 4B: ein detailliertes Flussdiagramm einer Ausführungsform des erfindungsgemäßen Verfahrens zur Herstellung einer Verbundscheibe.

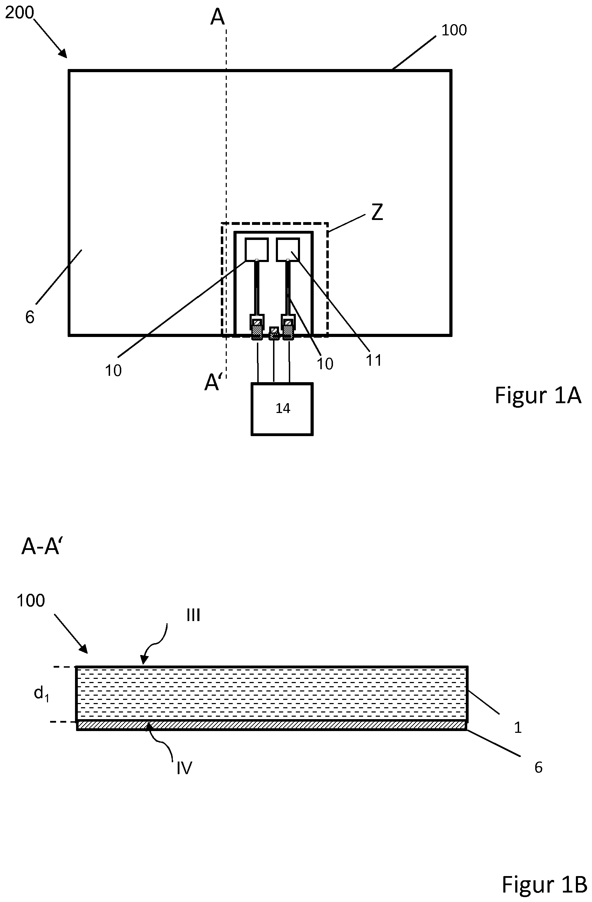

Figur 1A zeigt eine Draufsicht auf eine beispielhafte Ausgestaltung einer erfindungsgemäßen Scheibenanordnung 200 mit einer Fensterscheibe 100 am Beispiel einer Dachscheibe eines Kraftfahrzeugs.

In Figur 1B ist eine Querschnittsdarstellung entlang der Schnittlinie A-A' aus Figur 1A dargestellt. Die Fensterscheibe 100 umfasst hier beispielsweise eine einzelne Scheibe 1. Die Fensterscheibe 100 ist beispielsweise eine Fahrzeugscheibe und insbesondere die Dachscheibe eines Personenkraftwagens. Die Abmessungen der Fensterscheibe 100 betragen beispielsweise 0,9 m x 1,5 m. Die Fensterscheibe 100 enthält eine Scheibe 1, die beispielsweise dafür vorgesehen ist, in Einbaulage einen Fahrzeuginnenraum von einer äußeren Umgebung abzutrennen. Das heißt, die innenseitige Oberfläche IV der Scheibe 1 ist vom Innenraum aus zugänglich, wogegen die außenseitige Oberfläche III der Scheibe 1 bezüglich des Fahrzeuginnenraums nach außen weist. Die Scheibe 1 besteht beispielsweise aus Natron-Kalkglas und wurde im Floatverfahren hergestellt. Die Dicke d₁ der Scheibe 1 beträgt beispielsweise 2,1 mm. Prinzipiell kann die Scheibe 1 auch andere Dicken aufweisen. So kann die Scheibe 1 beispielsweise als Bauverglasung eine Dicke von 4 mm aufweisen.

Die Scheibe 1 wurde beispielsweise einer Temperbehandlung unterzogen und ist damit ein Einscheibensicherheitsglas.

Die innenseitige Oberfläche IV der Scheibe 1 ist mit einer Low-E-Beschichtung 6 beschichtet. In Tabelle 1 sind drei Beispiele für erfindungsgemäße Low-E-Beschichtungen 6 mit funktionellen Schichten aus beispielsweise ITO dargestellt. Jede Low-E-Beschichtung 6 der Beispiele 1-3 besteht aus einem Schichtstapel aus: Scheibe 1 / Haftschicht / funktioneller Schicht / Barriereschicht / Antireflexionsschicht.

**Tabelle 1**

| | Material | Dicke | | |
|---|---|---|---|---|
| | | Beispiel 1 | Beispiel 2 | Beispiel 3 |
| Antireflexionsschicht | SiO₂:Al | 45 nm | 40 nm | 80 nm |
| Barriereschicht | Si₃N₄:Al | 12 nm | 20 nm | 12 nm |
| Funktionelle Schicht | ITO | 120 nm | 120 nm | 120 nm |
| Haftschicht | SiO₂:Al | 30 nm | 30 nm | 40 nm |
| Scheibe bzw. Innenscheibe 1 | Kalk-Natronglas | | | |

Die in Figur 1A dargestellte Low-E-Beschichtung 6 besteht beispielsweise aus dem Schichtsystem nach Beispiel 1 aus Tabelle 1. In einem weiteren Beispiel besteht die in Figur 1A dargestellte Low-E-Beschichtung 6 aus dem Schichtsystem nach Beispiel 2 aus Tabelle 1 und in einem weiteren Beispiel aus dem Schichtsystem nach Beispiel 3 aus Tabelle 1.

Die Fensterscheibe 1 mit den beispielhaft genannten Schichtsystemen nach Beispiel 1-3 haben eine innenraumseitige, normale Gesamtemissivität von kleiner oder gleich 30% und einen Flächenwiderstand von 20 Ohm/Quadrat bis 30 Ohm/Quadrat. Die Fensterscheibe weist bei Reflexion beispielsweise einen Farbwert a* von -3 bis +4 und einen Farbwert b* von -7 bis +4 auf, betrachtet von der mit der Low-E-Beschichtung 6 versehenen Seite aus. Eine derartige Fensterscheibe 1 kann klar sein und beispielsweise eine Transparenz von größer oder gleich 80% im sichtbaren Bereich aufweisen. Zur Vermeidung von Blendung im sichtbaren Bereich durch Sonneneinstrahlung kann die Scheibe 1 auch stark getönt sein und lediglich eine Transparenz von kleiner oder gleich 20% im sichtbaren Bereich aufweisen. Es versteht sich, dass die Low-E-Beschichtung 6 auch aus anderen Schichtsystemen mit niedriger Emissivität bestehen kann.

Im unteren Abschnitt der Fensterscheibe 100 weist die Low-E-Beschichtung 6 beispielsweise zwei kapazitive Schaltbereiche 10 auf.

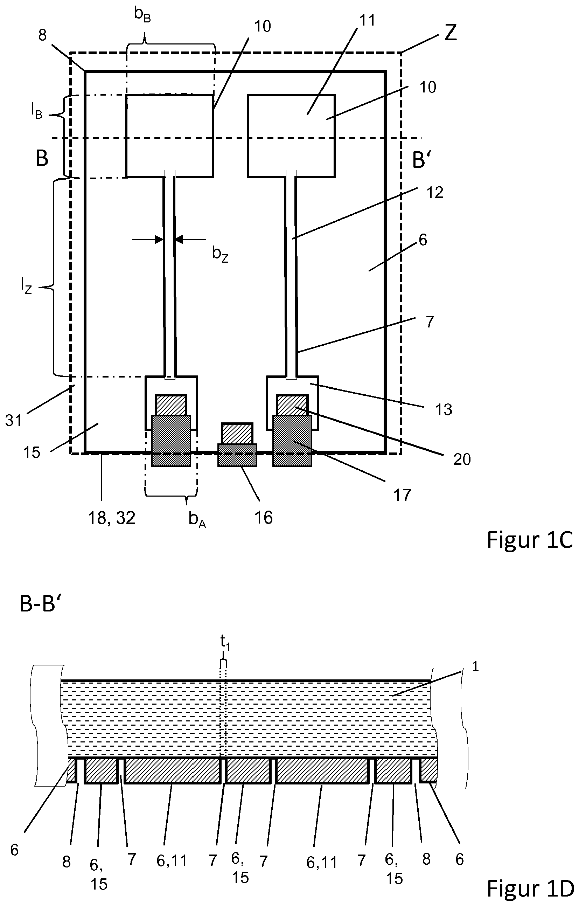

Figur 1C zeigt eine vergrößerte Darstellung des Ausschnitts Z der Fensterscheibe 100 aus Figur 1A mit dem kapazitiven Schaltbereich 10. Figur 1D zeigt eine dazugehörige Querschnittsdarstellung entlang der Schnittlinie B-B' aus Figur 1C.

Die Low-E-Beschichtung 6 ist durch beschichtungsfreie erste Trennlinien 7 in unterschiedliche, voneinander elektrisch isolierte Bereiche unterteilt. In diesem Beispiel bedeutet elektrisch isoliert, dass die Bereiche voneinander galvanisch getrennt sind, das heißt, dass kein Gleichstrom (DC) zwischen den Bereichen fließen kann. In dem in Figur 1C dargestellten Beispiel sind zwei kapazitive Schaltbereiche 10 von einem gemeinsamen Umgebungsbereich 15 elektrisch unterteilt. Die ersten Trennlinien 7 sind jeweils geschlossen. Der Umgebungsbereich 15 umgibt die beiden kapazitiven Schaltbereiche 18 vollständig. An einem (in Fig. 1C unteren) Scheibenrand 18 der Fensterscheibe 100 bzw. Scheibe 1 erstreckt sich der Umgebungsbereich 15 bis zum Beschichtungsrand 32 der Low-E-Beschichtung 6. Im vorliegenden Ausführungsbeispiel erstreckt sich der Rand der Low-E-Beschichtung 6 bis zum Rand der Scheibe 1, wobei gleichermaßen denkbar ist, dass der Rand der Low-E-Beschichtung 6 gegenüber dem Rand der Scheibe 1 rückversetzt ist.

Der Umgebungsbereich 15 ist durch eine die beiden kapazitiven Schaltbereiche 10 teilweise umgebende zweite Trennlinie 8, die in der Low-E-Beschichtung 6 ausgebildet ist, von einem den Umgebungsbereich 15 umgebenden (Außen-)Bereich 31 der Low-E-Beschichtung 6 elektrisch getrennt. Die zweite Trennlinie 8 ist in die Low-E-Beschichtung 6 eingeformt. Die zweite Trennlinie 8 ist nicht geschlossen und erstreckt sich frei endend bis zum Beschichtungsrand 32 der Low-E-Beschichtung 6, wobei die zweite Trennlinie 8 dort nicht vorhanden ist, wo sich der Umgebungsbereich 15 bis zum Beschichtungsrand 32 erstreckt. Der Außenbereich 31 umgibt den Umgebungsbereich 15 somit nur teilweise, nicht vollständig. Der Umgebungsbereich 15 und der Außenbereich 31 (d.h. voneinander verschiedene Bereiche der Low-E-Beschichtung 6, die durch die zweite Trennlinie 8 voneinander getrennt sind) sind somit voneinander elektrisch isolierte Bereiche der Low-E-Beschichtung 6. Dies bedeutet, dass der Umgebungsbereich 15 und der Außenbereich 31 voneinander galvanisch getrennt sind, so dass kein Gleichstrom (DC) zwischen dem Umgebungsbereich 15 und dem Außenbereich 31 fließen kann. Denkbar ist jedoch auch, dass sich der Umgebungsbereich 15 nicht bis zum Beschichtungsrand 32 erstreckt, wobei die zweite Trennlinie 8 in diesem Fall geschlossen ist und den Umgebungsbereich 15 vollständig umgibt. In diesem Fall umgibt der Außenbereich 31 den Umgebungsbereich 15 vollständig.

Jeder Schaltbereich 10 umfasst einen Berührungsbereich 11, der annähernd quadratisch ausgebildet ist und in einen streifenförmigen Zuleitungsbereich 12 übergeht. Die Breite b_{B} und die Länge I_{B} des Berührungsbereichs 11 beträgt jeweils beispielsweise 40 mm. Die Breite b_{Z} des Zuleitungsbereichs 12 beträgt beispielsweise 1 mm. Das Verhältnis von b_{Z}:b_{B} beträgt somit etwa 1:40. Der Zuleitungsbereich 12 ist mit einem ersten Anschlussbereich 13 verbunden. Der erste Anschlussbereich 13 hat eine quadratische Form und einer Kantenlänge b_{A} von beispielsweise 12 mm. Die Länge I_{Z} des Zuleitungsbereichs beträgt etwa 48 mm. Der Umgebungsbereich 15 ist wiederum durch eine erste Trennlinie 7 von der restlichen Low-E-Beschichtung 6 abgetrennt. Der Umgebungsbereich 15 ist hier rechteckig ausgestaltet und umfasst beide kapazitiven Schaltbereiche 10. Der Umgebungsbereich 15 weist einen weiteren bzw. zweiten Anschlussbereich 16 auf. Der zweite Anschlussbereich 16 kann beliebig innerhalb des Umgebungsbereichs 15 angeordnet sein. Im dargestellten Beispiel ist er am unteren Rand des Umgebungsbereichs 15 am unteren Rand der Scheibe 1 angeordnet. Er ist dadurch optisch unauffällig und behindert die Durchsicht nur wenig.

Die erste Trennlinie 7 hat lediglich eine Breite t₁ von beispielsweise 100 µm und ist beispielsweise durch Laserstrukturierung in die Low-E-Beschichtung 6 eingebracht. Entsprechendes gilt für die zweite Trennlinie 8. Trennlinien 7, 8 mit einer derart geringen Breite sind optisch kaum wahrnehmbar und stören die Durchsicht durch die Fensterscheibe 100 nur wenig, was besonders ästhetisch ist und besonders für eine Verwendung im Sichtbereich von Fahrzeugen von besonderer Wichtigkeit für die Fahrsicherheit ist.

Der erste Anschlussbereich 13 ist über eine elektrische Leitungsverbindung 20 mit einem Folienleiter 17 elektrisch leitend verbunden. Eine sichere elektrisch leitende Verbindung wird dabei bevorzugt durch einen elektrisch leitfähigen Kleber erzielt. Der Folienleiter 17 besteht beispielsweise aus einer 50 µm dicken Kupferfolie und ist beispielsweise außerhalb des ersten Anschlussbereichs 13 mit einer Polyimidschicht isoliert. Dadurch kann der Folienleiter 17 ohne elektrischen Kurzschluss über den Umgebungsbereich 15 hinweg über den unteren Rand der Fensterscheibe 100 hinausgeführt werden. Es versteht sich, dass die elektrische Leitungsverbindung des zweiten Anschlussbereichs 16 nach außen auch über isolierte Drähte oder über einen Bereich, in dem die Low-E-Beschichtung des Umgebungsbereichs unterbrochen ist, nach außen geführt werden kann.

Der Folienleiter 17 ist hier beispielsweise außerhalb der Fensterscheibe 100 mit einer kapazitiven Sensorelektronik 14 verbunden. Des Weiteren ist der Umgebungsbereich 15 über den zweiten Anschlussbereich 16 ebenfalls mit der Sensorelektronik 14 verbunden. Die Sensorelektronik 14 ist dazu geeignet, Kapazitätsänderungen des Schaltbereichs 10 gegenüber dem Umgebungsbereich 15 präzise zu messen und in Abhängigkeit eines Schwellwerts ein Schaltsignal beispielsweise an den CAN-Bus eines Fahrzeugs weiter zu geben. Über das Schaltsignal können beliebige Funktionen im Fahrzeug geschaltet werden. Beispielsweise kann eine Beleuchtung in oder an der Fensterscheibe 100 ein- oder ausgeschaltet werden.

Wird die Fensterscheibe 100 beispielsweise als Dachscheibe in einem Kraftfahrzeug verwendet, kann die Länge des Zuleitungsbereichs 12 so gewählt werden, dass der Fahrer des Fahrzeugs, der Beifahrer oder Insassen auf der Rückbank des Fahrzeugs den Berührungsbereich 11 des Schaltbereichs 10 bequem erreichen.

Im dargestellten Ausgestaltungsbeispiel ist der Aufbau und die Abstimmung der Sensorelektronik 14 derart abgestimmt, dass bei Berührung der innenseitigen Oberfläche IV der Scheibe 1 über dem Berührungsbereich 11 des kapazitiven Schaltbereichs 10 ein Schaltsignal ausgelöst wird, wobei bei Berührung der außenseitigen Oberfläche III der Scheibe 1 über dem kapazitiven Schaltbereich 10 kein Schaltsignal ausgelöst wird.

Des Weiteren ist in diesem Beispiel die Fläche des Berührungsbereichs 11 und insbesondere dessen Breite b_{B} derart mit der Breite b_{Z} des Zuleitungsbereichs 12 abgestimmt, dass nur bei einer Berührung der innenseitigen Oberfläche IV der Scheibe 1 über dem Berührungsbereichs 11 (also in demjenigen Bereich der Oberfläche IV, der sich durch orthogonale Projektion des Berührungsbereichs 11 auf die Oberfläche IV ergibt) ein Schaltsignal ausgibt und nicht bei Berührung der Oberfläche IV über dem Zuleitungsbereich 12.

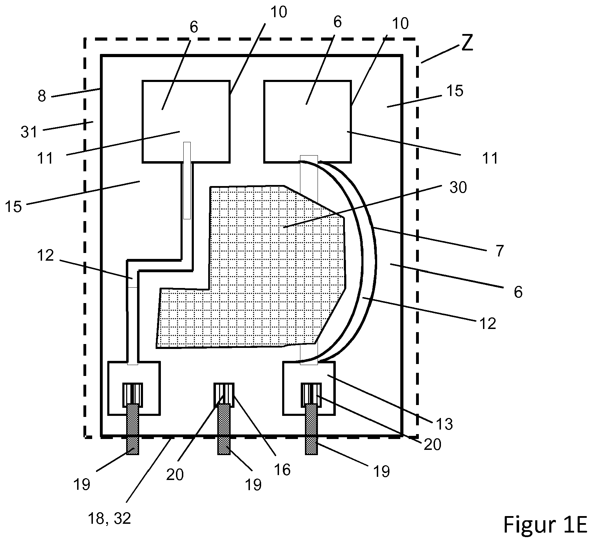

Figur 1E zeigt eine vergrößerte Darstellung eines Ausschnitts Z nach Figur 1A einer alternativen Ausgestaltung der Fensterscheibe 100. Das dargestellte Ausführungsbeispiel entspricht im Aufbau im Wesentlichen der Fensterscheibe 100 nach Figur 1A, so dass im Folgenden nur auf die jeweiligen Unterschiede eingegangen wird. Die Low-E-Beschichtung 6 weist in diesem Beispiel einen beschichtungsfreien Bereich 30 auf, der beispielsweise als Kommunikationsfenster dient und für elektromagnetische Strahlung, beispielsweise für GSP-Empfang oder Mobilfunk, transparent ist. Im hier dargestellten Ausgestaltungsbeispiel sind die Zuleitungsbereiche 12 deshalb nicht geradlinig ausgestaltet, sondern um den beschichtungsfreien Bereich 30 herum geführt. Im Zuleitungsbereich 12, der zum im der Figur 1E links angeordneten kapazitiven Schaltbereich 10 gehört, ist der Zuleitungsbereich 12 beispielsweise als ein streifenförmiger Bereich mit zwei rechten Winkeln ausgebildet (doppel-L-Struktur).

Im Zuleitungsbereich 12, der zum in der Figur 1E rechts angeordneten kapazitiven Schaltbereich 10 gehört, ist der Zuleitungsbereich 12 beispielsweise als ein bogenförmiger Bereich ausgebildet. Es versteht sich, dass auch jeder andere zweckmäßige Verlauf des Zuleitungsbereichs 12 möglich ist.

Der Umgebungsbereich 15 ist in diesem Beispiel durch eine zweite Trennlinie 8 von der umgebenden Low-E-Beschichtung abgetrennt, so dass nicht die gesamte umgebende Low-E-Beschichtung 6 als Umgebungsbereich 15 wirken kann. Der Umgebungsbereich 15 der Low-E-Beschichtung 6 ist hier über einen zweiten Anschlussbereich 16 mit der kapazitiven Sensorelektronik 14 verbunden.

Des Weiteren sind in diesem Ausgestaltungsbeispiel die ersten Anschlussbereiche 13, bzw. der zweite Anschlussbereich 16 mit metallische Drähten in Form von mit Kunststoff isolierten Rundleitern 19 elektrisch leitend verbunden. Dabei erfolgt die elektrische Leitungsverbindung 20 zwischen Anschlussbereich 13,19 und Rundleiter 19 über ein Crimp-Element, dass an das eine Ende des Rundleiters 19 gecrimpt ist, wobei das Crimp-Element durch Ultraschal-Löten mit dem Anschlussbereich 13,19 elektrisch leitend verbunden ist.

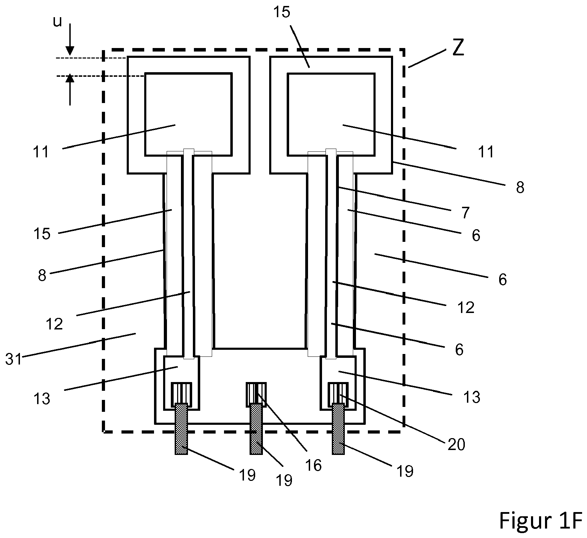

Figur 1F zeigt eine vergrößerte Darstellung eines Ausschnitts Z nach Figur 1A einer weiteren alternativen Ausgestaltung der Fensterscheibe 100. Das dargestellte Ausführungsbeispiel entspricht im Aufbau im Wesentlichen der Fensterscheibe 100 nach Figur 1A, so dass im Folgenden nur auf die jeweiligen Unterschiede eingegangen wird.

Der Umgebungsbereich 15 bzw. die zweite Trennlinie 8 ist in diesem Beispiel rahmenförmig um die kapazitive Schaltfläche 10 und damit um den Berührungsbereich 11, den Zuleitungsbereich 12 und den Anschlussbereich 13 ausgebildet. Die zweite Trennlinie 8, die den unmittelbaren Umgebungsbereich 15 von der kapazitiven Schaltfläche 10 bzw. der ersten Trennlinie 8 abtrennt, weist einen (kürzesten) Abstand u zwischen 5 mm und 10 mm zum Berührungsbereich 11, zum Zuleitungsbereich 12 und abschnittsweise zum Anschlussbereich 13 auf und definiert damit die Breite des Umgebungsbereichs 15. Lediglich im Anschlussbereich 13, 16 ist der Abstand und damit die Breite u des Umgebungsbereichs 15 größer ausgestaltet, damit genügend Platz für das weitere Anschlusselement 16 zur elektrischen Kontaktierung des Umgebungsbereichs 15 zur Verfügung steht.

Eine derartige rahmenförmige Ausgestaltung des Umgebungsbereichs 15 ist besonders vorteilhaft, weil hierdurch eine besondere gute Signalqualität der kapazitiven Schaltflächen 10 erreicht werden kann. Des Weiteren ermöglicht das Abtrennen des Umgebungsbereichs 15 vom Außenbereich 31, insbesondere mit einer rahmenförmigen Ausgestaltung des Umgebungsbereichs 15, in vorteilhafter Weise das Einbringen weiterer elektrischer Einrichtungen in die Low-E-Beschichtung.

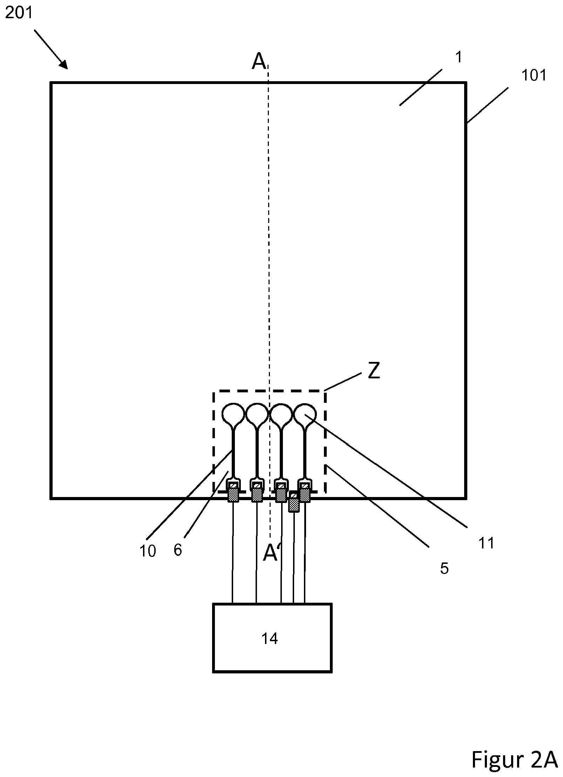

Figur 2A zeigt eine Draufsicht auf eine alternative beispielhafte Ausgestaltung einer erfindungsgemäßen Scheibenanordnung 201 mit einer Verbundscheibe 101.

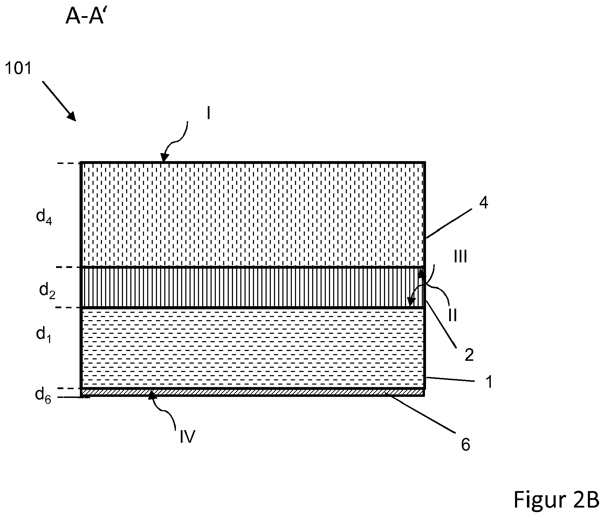

In Figur 2B ist eine Querschnittsdarstellung entlang der Schnittlinie A-A' aus Figur 2A dargestellt. Die Verbundscheibe 101 umfasst hier beispielsweise eine Innenscheibe 1 und eine Außenscheibe 4, die über eine Zwischenschicht 2 miteinander verbunden sind. Die Innenscheibe 1 entspricht in ihrer Funktion der Scheibe 1 aus Figur 1A. Die Verbundscheibe 101 ist beispielsweise Teil einer Fassadenverglasung und beispielsweise ein Fenster, das den Innenraum eines Gebäudes von einer äußeren Umgebung abtrennt. Gleichwohl kann eine derartige Verbundscheibe 100 auch als Fahrzeugverglasung und insbesondere als Dachscheibe eines Personenkraftwagens ausgebildet sein.

Die Abmessungen der Verbundscheibe 101 betragen beispielsweise 1,2 m x 1,2 m. Die Innenscheibe 1 ist beispielsweise dafür vorgesehen, in Einbaulage dem Innenraum zugewandt zu sein. Das heißt, die innenseitige Oberfläche IV der Innenscheibe 1 ist vom Innenraum aus zugänglich, wogegen die außenseitige Oberfläche I der Außenscheibe 4 nach außen weist. Innenscheibe 1 und Außenscheibe 4 bestehen beispielsweise aus Natron-Kalkglas, welches in einem Floatverfahren hergestellt wurde. Innenscheibe 1 und Außenscheibe 4 können ungetempert oder getempert sein. Die Dicke d₁ der Innenscheibe 1 beträgt beispielsweise 2,1 mm und die Dicke d₄ der Außenscheibe 4 beträgt beispielsweise ebenfalls 2,1 mm. Die Zwischenschicht 2 ist eine thermoplastische Zwischenschicht und besteht beispielsweise aus Polyvinylbutyral (PVB). Sie weist eine Dicke d₂ von beispielsweise 0,76 mm auf.

Die innenseitige Oberfläche IV der Innenscheibe 1 ist mit einer Low-E-Beschichtung 6 beschichtet. Die in Figur 2A dargestellte Low-E-Beschichtung 6 besteht beispielsweise aus dem Schichtsystem nach Beispiel 1 aus Tabelle 1. In einem weiteren Beispiel besteht die in Figur 2A dargestellte Low-E-Beschichtung 6 aus dem Schichtsystem nach Beispiel 2 aus Tabelle 1 und in einem weiteren Beispiel aus dem Schichtsystem nach Beispiel 3 aus Tabelle 1.

Im mittleren, unteren Abschnitt der Verbundscheibe 101 weist die Low-E-Beschichtung 6 einen kapazitiven Schaltbereich 10 auf. Es versteht sich, dass der kapazitive Schaltbereich 10 auch in jedem anderen Abschnitt der Verbundscheibe 101 angeordnet sein kann.

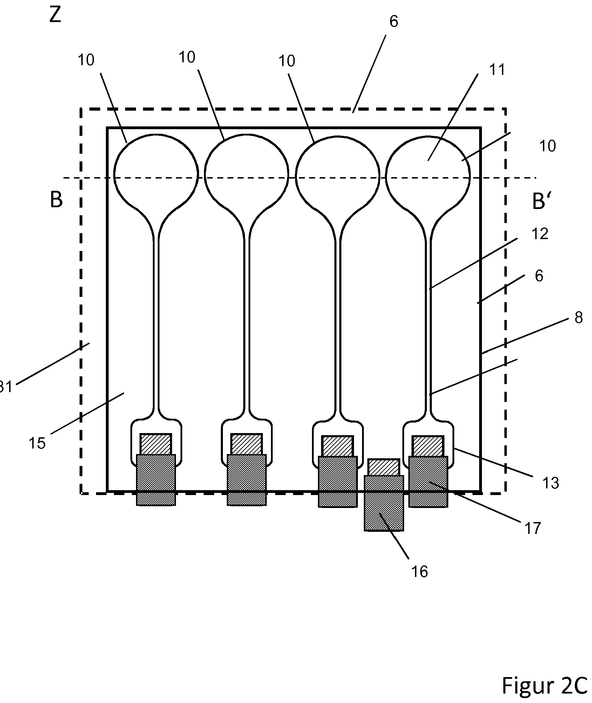

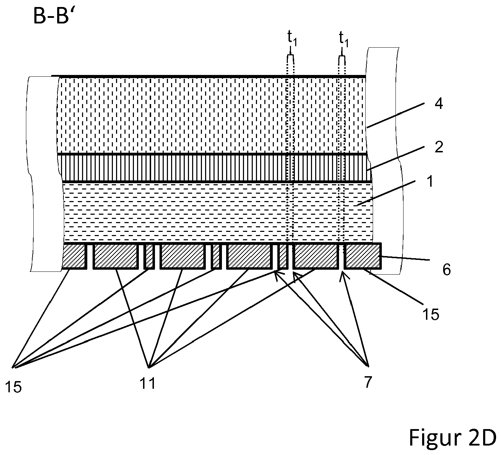

Figur 2C zeigt eine vergrößerte Darstellung des Ausschnitts Z aus Figur 2A. Figur 2D zeigt eine dazugehörige Querschnittsdarstellung entlang der Schnittlinie B-B' aus Figur 2C.

Die Low-E-Beschichtung 6 ist durch beschichtungsfreie erste Trennlinien 7 in unterschiedliche, voneinander elektrisch isolierte Bereiche unterteilt. In dem in Figur 2C dargestellten Beispiel sind vier kapazitive Schaltbereiche 10 von einem gemeinsamen Umgebungsbereich 15 elektrisch unterteilt. Jeder Schaltbereich 10 umfasst einen Berührungsbereich 11, der annähernd tropfenförmig ausgebildet ist und in einen streifenförmigen Zuleitungsbereich 12 übergeht. Die Breite b_{B} und die Länge I_{B} des Berührungsbereichs 11 beträgt jeweils beispielsweise 40 mm. Die Breite b_{Z} des Zuleitungsbereichs 12 beträgt beispielsweise 1 mm. Das Verhältnis von b_{Z}:b_{B} beträgt somit etwa 1:40. Der Zuleitungsbereich 12 ist mit einem Anschlussbereich 13 verbunden. Der Anschlussbereich 13 hat eine quadratische Form mit abgerundeten Ecken und einer Kantenlänge b_{A} von beispielsweise 12 mm. Die Länge I_{Z} des Zuleitungsbereichs beträgt etwa 48 mm.

Die erste Trennlinie 7 hat lediglich eine Breite t₁ von beispielsweise 100 µm und ist beispielsweise durch Laserstrukturierung in die Low-E-Beschichtung 6 eingebracht. Trennlinien 7 mit einer derart geringen Breite sind optisch kaum wahrnehmbar und stören die Durchsicht durch die Verbundscheibe 101 nur wenig, was besonders für eine Verwendung als Fenster von Gebäuden oder in Fahrzeugen als Dachscheibe besonders ästhetisch ist. Gezeigt ist weiterhin eine zweite Trennlinie 8, welche die kapazitiven Schaltflächen 10 vollständig umgibt und den Umgebungsbereich 15 vom Außenbereich der Low-E-Beschichtung 6 vollständig elektrisch trennt..

Der erste Anschlussbereich 13 ist über eine elektrische Leitungsverbindung 20 mit einem Folienleiter 17 elektrisch leitend verbunden. Eine sichere elektrisch leitende Verbindung wird dabei bevorzugt durch einen elektrisch leitfähigen Kleber erzielt. Der Folienleiter 17 besteht beispielsweise aus einer 50 µm dicken Kupferfolie und ist beispielsweise außerhalb der ersten Anschlussbereichs 13 mit einer Polyimidschicht isoliert. Dadurch kann der Folienleiter 17 ohne elektrischen Kurzschluss über den Umgebungsbereich 15 hinweg über den unteren Rand der Verbundscheibe 101 hinausgeführt werden. Es versteht sich, dass die elektrische Verbindung des ersten Anschlussbereichs 13 nach außen auch über isolierte Drähte oder über einen Bereich der Low-E-Beschichtung 6, in dem der Umgebungsbereich 15 unterbrochen ist, nach außen geführt werden kann.

Der Folienleiter 17 ist hier beispielsweise außerhalb der Verbundscheibe 101 mit einer kapazitiven Sensorelektronik 14 verbunden. Des Weiteren ist der Umgebungsbereich 15 über einen zweiten Anschlussbereich 16 ebenfalls mit der Sensorelektronik 14 verbunden. Die Sensorelektronik 14 ist dazu geeignet Kapazitätsänderungen des Schaltbereichs 10 gegenüber dem Umgebungsbereich 15 präzise zu messen und in Abhängigkeit eines Schwellwerts ein Schaltsignal beispielsweise an den CAN-Bus eines Fahrzeugs weiter zu geben. Über das Schaltsignal können beliebige Funktionen im Fahrzeug geschaltet werden. Beispielsweise kann die Verbundscheibe 101 eine Suspended Particle Device (SPD)- , eine elektrochrome oder eine andersartige Schicht oder Folie zur Steuerung der optischen Transparenz aufweisen, die durch das Schaltsignal in ihrer optischen Transparenz verändert werden kann, hier zum Beispiel mit vier Transparenzstufen, die jeweils über die vier kapazitiven Schaltbereiche angewählt werden können. Es versteht sich, dass alternativ oder zusätzlich auch andere elektrische Funktionen wie eine elektrische Beheizung oder eine elektrische Beleuchtung gesteuert werden können. Derartige funktionelle Schichten oder Bauelemente zur Steuerung der optischen Transparenz, der elektrischen Beheizung oder elektrischen Beleuchtung können an beliebigen Positionen an oder in der Verbundscheibe 101 angeordnet sein, und beispielsweise über eine oder mehrere Zwischenschichten im inneren der Verbundscheibe 101 einlaminiert sein.

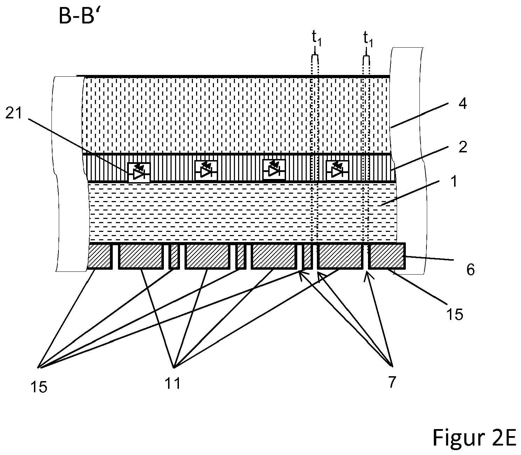

Figur 2E zeigt eine alternative Ausgestaltung, bei der vier Leuchtdioden (LED) 21 zwischen Innenscheibe 1 und Außenscheibe 4 in die Verbundscheibe 101 einlaminiert wurden. Gleichwohl kann eine oder mehrere LEDs oder andere Lichteinstrahlmittel am Rand der Verbundscheibe 101, Licht beispielsweise in die Innenscheibe 1 einkoppeln. Das Licht kann dann über Lichtablenkmittel, wie eine Aufrauhung der außenseitigen Oberfläche III der Innenscheibe 1 im Bereich der kapazitiven Schaltfläche 10 ausgekoppelt werden und diese optisch markieren.

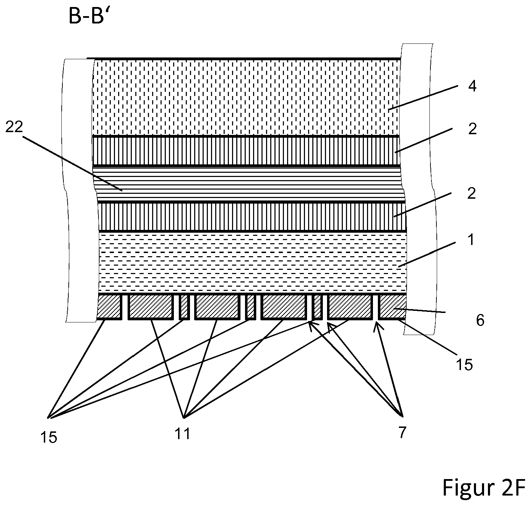

Figur 2F zeigt eine weitere alternative Ausgestaltung, bei der eine funktionelle Zwischenschicht 22 zwischen Innenscheibe 1 und Außenscheibe 4 in die Verbundscheibe 101 einlaminiert wurden. Die funktionelle Zwischenschicht 22 ist hier beispielsweise über zwei thermoplastische Zwischenschichten 2 aus einer PVB-Folie mit der Innenscheibe 1 und der Außenscheibe 4 verbunden. Die funktionelle Zwischenschicht 22 weist beispielsweise eine elektrisch steuerbare, optische Transparenz auf und enthält bevorzugt eine Suspended Particle Device (SPD)-Schicht oder eine elektrochrome Zwischenschicht.

Wird die Verbundscheibe 101 beispielsweise als Dachscheibe in einem Kraftfahrzeug verwendet, kann die Länge des Zuleitungsbereichs 12 so gewählt werden, dass der Fahrer des Fahrzeugs, der Beifahrer oder Mitfahrer auf den hinteren Sitzplätzen den Berührungsbereich 11 des Schaltbereichs 10 bequem erreichen. Es versteht sich, dass dazu auch mehrere kapazitive Schaltflächen 10 in der Verbundscheibe 100 angeordnet werden können, beispielsweise jeweils eine für jeden Fahrzeuginsassen.

Im dargestellten Beispiel ist die Aufbau und die Abstimmung der Sensorelektronik 14 derart abgestimmt, dass bei Berührung der innenseitigen Scheibenoberfläche IV der Scheibe 1 über dem Berührungsbereich 11 des kapazitiven Schaltbereichs 10 ein Schaltsignal ausgelöst wird, wobei bei Berührung der außenseitigen Oberfläche I der Außenscheibe 4 kein Schaltsignal ausgelöst wird. Dies hat den besonderen Vorteil, dass durch beabsichtigte oder versehentliche Berührung der Verbundscheibe 101 von außerhalb des Fahrzeugs kein Schaltsignal ausgelöst werden kann. Außerdem wird die versehentliche Auslösung eines Schaltsignals, beispielsweise durch Regen oder eine Waschanlage, vermieden.

Des Weiteren ist in diesem Beispiel die Fläche des Berührungsbereichs 11 und insbesondere dessen Breite b_{B} derart mit der Breite b_{Z} des Zuleitungsbereichs 12 abgestimmt, dass nur bei einer Berührung der innenseitigen Oberfläche IV der Innenscheibe 1 über dem Berührungsbereichs 11 (also in demjenigen Bereich der innenseitigen Oberfläche IV, der sich durch orthogonale Projektion des Berührungsbereichs 11 auf die innenseitige Oberfläche IV ergibt) ein Schaltsignal ausgibt und nicht bei Berührung der innenseitigen Oberfläche IV der Innenscheibe 1 über dem Zuleitungsbereich 12.

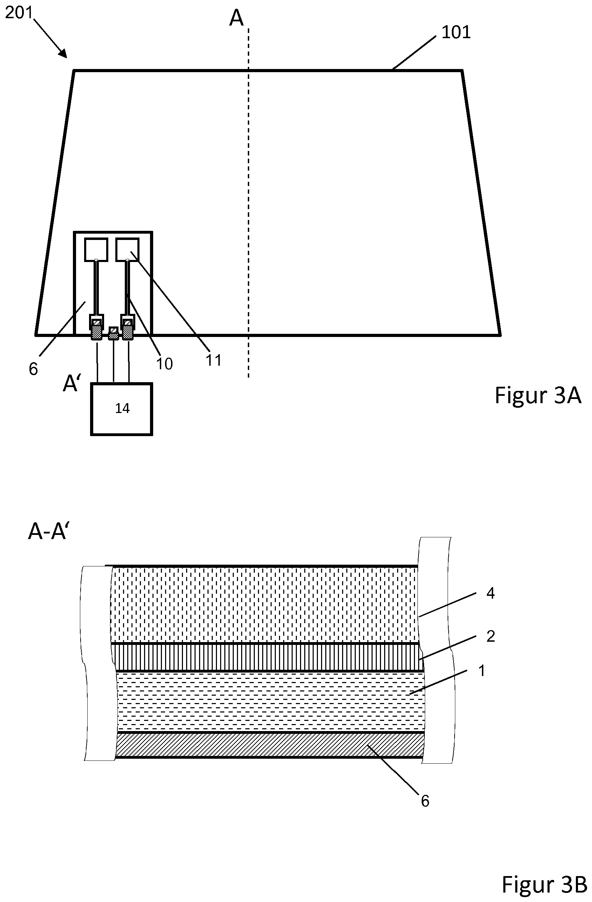

Figur 3A zeigt eine weitere Ausgestaltung der Verbundscheibe 101 am Beispiel einer Windschutzscheibe in einer Ansicht auf die innenseitige Oberfläche IV der Innenscheibe 1, also von der Position der Fahrzeuginsassen aus gesehen.

In Figur 3B ist eine Querschnittsdarstellung entlang der Schnittlinie A-A' aus Figur 3A dargestellt. Der Aufbau der Verbundscheibe 101 aus Figur 3A entspricht beispielsweise dem Aufbau der Verbundscheibe 101 aus Figur 2A, wobei lediglich die Abmessungen der Verbundscheibe 101 für einen Einbau als Windschutzscheibe ausgestaltet wurden. Die kapazitiven Schaltflächen 10 wurden zur besseren Erreichbarkeit durch den Fahrzeugführer am linken unteren Rand, außerhalb des zentralen Sichtfeldes angeordnet.

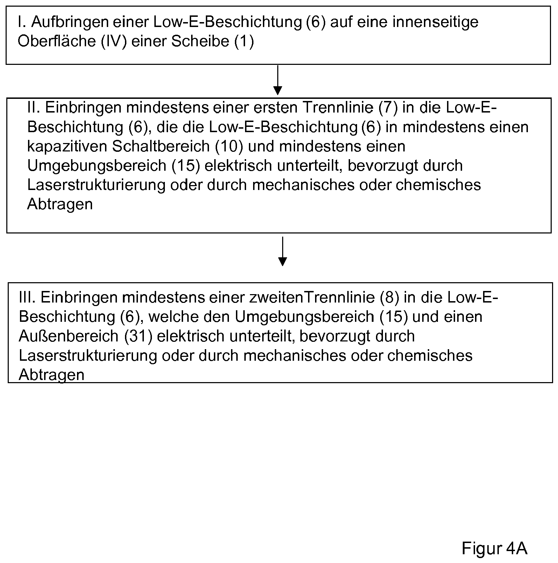

Figur 4A zeigt ein Flussdiagramm eines Ausführungsbeispiels des erfindungsgemäßen Verfahrens zur Herstellung einer erfindungsgemäßen Scheibenanordnung 200 mit Fensterscheibe 100 mit kapazitivem Schaltbereich 10.

Das erfindungsgemäße Verfahren umfasst die folgenden Schritte:
I. Aufbringen einer Low-E-Beschichtung (6) auf eine innenseitige Oberfläche (IV) einer Scheibe (1),
II. Einbringen mindestens einer ersten Trennlinie (7), die die Low-E-Beschichtung (6) in mindestens einen kapazitiven Schaltbereich (10) und mindestens einen Umgebungsbereich (15) elektrisch unterteilt, bevorzugt durch Laserstrukturierung oder durch mechanisches oder chemisches Abtragen,
III. Einbringen mindestens einer zweiten Trennlinie (8) in die Low-E-Beschichtung (6), welche den Umgebungsbereich (15) und einen Außenbereich der Low-E-Beschichtung (6) elektrisch unterteilt, bevorzugt durch Laserstrukturierung oder durch mechanisches oder chemisches Abtragen.

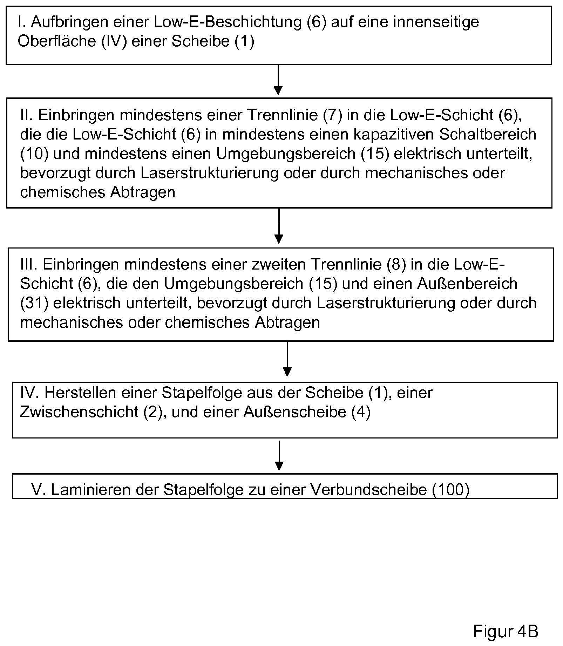

Figur 4B zeigt ein Flussdiagramm eines Ausführungsbeispiels des erfindungsgemäßen Verfahrens zur Herstellung einer Verbundscheibe 101 mit kapazitivem Schaltbereich 10.

Das erfindungsgemäße Verfahren umfasst die folgenden Schritte:
I. Aufbringen einer Low-E-Beschichtung (6) auf eine innenseitige Oberfläche (IV) einer Scheibe (1);
II. Einbringen mindestens einer ersten Trennlinie (7), die die Low-E-Schicht (6) in mindestens einen kapazitiven Schaltbereich (10) und mindestens einen Umgebungsbereich (15) der Low-E-Beschichtung (6) elektrisch unterteilt, bevorzugt durch Laserstrukturierung oder durch mechanisches oder chemisches Abtragen;
III. Einbringen mindestens einer zweiten Trennlinie (8) in die Low-E-Beschichtung (6), welche den Umgebungsbereich (15) und einen Außenbereich der Low-E-Beschichtung (6) elektrisch unterteilt, bevorzugt durch Laserstrukturierung oder durch mechanisches oder chemisches Abtragen,
IV. Herstellen einer Stapelfolge aus der Scheibe (1), einer Zwischenschicht (2), und einer Außenscheibe (4) und
V. Laminieren der Stapelfolge zu einer Verbundscheibe (100).

Die erfindungsgemäße Scheibenanordnung mit Fensterscheibe 100 nach Figur 1 und die Verbundscheiben 102 nach den Figuren 2 und 3 weisen einen kapazitiven Schaltbereich 10 auf, der beispielsweise mit einer kapazitiven Sensorelektronik 14 verbindbar ist. Außerdem ist, durch die geringe Breite der Trennlinien 7, die Sicht durch die Fenster- bzw. Verbundscheibe nur minimal beeinträchtigt und genügt beispielsweise den Anforderungen an eine Fahrzeugverglasung.

Besonders vorteilhaft und überraschend ist eine Scheibenanordnung 200 mit einer Fensterscheibe 100 bzw. eine Scheibenanordnung 201 mit einer Verbundscheibe 101, bei der die Empfindlichkeit der Sensorelektronik 14 derart abgestimmt ist, dass eine selektive Auslösung des Schaltvorgangs nur von einer innenseitigen Oberfläche IV der Fensterscheibe 100 bzw. der Verbundscheibe 101 möglich ist.

### Bezugszeichenliste:

- 1: Scheibe, Innenscheibe
- 2: Zwischenschicht
- 4: Außenscheibe
- 6: Low-E-Beschichtung
- 7: erste Trennlinie
- 8: zweite Trennline
- 10: kapazitiver Schaltbereich
- 11: Berührungsbereich
- 12: Zuleitungsbereich
- 13: erster Anschlussbereich
- 14: kapazitive Sensorelektronik
- 15: Umgebungsbereich
- 16: zweiter Anschlussbereich
- 17: Folienleiter
- 18: Scheibenrand
- 19: Rundleiter, Litzenleiter
- 20: elektrische Leitungsverbindung
- 21: Leuchtdiode (LED)
- 22: funktionelle Zwischenschicht
- 30: beschichtungsfreier Bereich
- 31: Außenbereich
- 32: Beschichtungsrand
- 100: Fensterscheibe
- 101: Verbundscheibe
- 200,201: Scheibenanordnung

- A: Fläche des Berührungsbereichs 11
- b_{A}: Breite des Anschlussbereichs 13
- b_{B}: Breite des Berührungsbereichs 11
- b_{Z}: Breite des Zuleitungsbereichs 12
- d₁,d₂,d₄,d₆: Dicke
- ε₀: elektrische Feldkonstante
- ε_{r,1}, ε_{r,2}, ε_{r,4},: relative Permittivität
- u: Breite des Umgebungsbereichs 15, Abstand der Trennlinie 7 des Umgebungsbereichs 15 zur Trennlinie 7 der kapazitiven Schaltfläche 10

- I_{A}: Länge des Anschlussbereichs 13
- I_{B}: Länge des Berührungsbereichs 11
- I_{Z}: Länge des Zuleitungsbereichs 12
- t₁: Breite der Trennlinie 7
- A-A': Schnittlinie
- B-B': Schnittlinie
- Z: Ausschnitt
- I: außenseitige Oberfläche der Außenscheibe 4
- II: innenseitige Oberfläche der Außenscheibe 4
- III: außenseitige Oberfläche der Scheibe 1 oder der Innenscheibe 1
- IV: innenseitige Oberfläche der Scheibe 1 oder der Innenscheibe 1

## Patentansprüche

1. Scheibenanordnung (101), umfassend:
- eine Scheibe (1) mit einer innenseitigen Oberfläche (IV) und einer außenseitigen Oberfläche (III),
- eine Low-E-Beschichtung (6), die zumindest teilweise auf der innenseitigen Oberfläche (IV) der Scheibe (1) angeordnet ist,
- mindestens eine in die Low-E-Beschichtung (6) eingeformte, beschichtungsfreie erste Trennlinie (7), durch die mindestens ein kapazitiver Schaltbereich (10) von einem Umgebungsbereich (15) der Low-E-Beschichtung (6) elektrisch abgetrennt ist, wobei der Umgebungsbereich (15) den kapazitiven Schaltbereich (10) zumindest abschnittsweise, insbesondere vollständig, umgibt, und wobei der kapazitive Schaltbereich (10) einen Berührungsbereich (11), einen Zuleitungsbereich (12) und einen ersten Anschlussbereich (13) aufweist, wobei der Zuleitungsbereich (12) den Berührungsbereich (11) mit dem ersten Anschlussbereich (13) elektrisch verbindet,
- mindestens eine in die Low-E-Beschichtung (6) eingeformte, beschichtungsfreie zweite Trennlinie (8), durch die der Umgebungsbereich (15) von einem Außenbereich (31) der Low-E-Beschichtung (6) elektrisch abgetrennt ist, wobei der Außenbereich (31) den Umgebungsbereich (15) zumindest teilweise, insbesondere vollständig umgibt,
- eine kapazitive Sensorelektronik (14), die mit dem ersten Anschlussbereich (13) des kapazitiven Schaltbereichs (10) und über einen zweiten Anschlussbereich (16) mit dem Umgebungsbereich (15) elektrisch verbunden ist.

2. Scheibenanordnung (101) nach Anspruch 1, bei welcher ein kürzester Abstand zwischen der ersten Trennlinie (7) und der zweiten Trennlinie (8) im Bereich von 0,1 mm bis 200 cm, bevorzugt im Bereich von 0,5 mm bis 100 mm, und besonders bevorzugt im Bereich von 1 mm bis 11 mm liegt.

3. Scheibenanordnung (101) nach Anspruch 1 oder 2, bei welcher ein kürzester Abstand zwischen der ersten Trennline (7) und der zweiten Trennline (8) in einem den Berührungsbereich (11) und/oder den Zuleitungsbereich (12) und/oder den Anschlussbereich (13) umgebenden Abschnitt der zweiten Trennlinie (8) unverändert ist.

4. Scheibenanordnung (101) nach einem der Ansprüche 1 bis 3, bei welcher die zweite Trennlinie (8) den kapazitiven Schaltbereich (10) rahmenförmig umgibt.

5. Scheibenanordnung (101) nach einem der Ansprüche 1 bis 4, wobei eine Länge I_{Z} des Zuleitungsbereichs (12) im Bereich von 1 cm bis 70 cm, vorzugsweise im Bereich von 1 cm bis 12 cm, besonders bevorzugt im Bereich von 3 cm bis 8 cm, liegt und wobei eine sich senkrecht zur Länge I_{Z} bemessende Breite b_{Z} des Zuleitungsbereichs (12) im Bereich von 0,5 mm bis 10 mm, vorzugsweise im Bereich von 0,5 mm bis 2 mm, liegt, und wobei ein Verhältnis von Breite b_{Z} zu Länge I_{Z} des Zuleitungsbereichs (12) kleiner oder gleich 1:700 und vorzugsweise kleiner oder gleich von 1:3 bis 1:100 ist.

6. Scheibenanordnung (101) nach einem der Ansprüche 1 bis 5, wobei der Berührungsbereich (11) eine Länge I_{B} im Bereich von 1 cm bis 14 cm, vorzugsweise im Bereich von 1 cm bis 3 cm, aufweist und wobei eine sich senkrecht zur Länge I_{B} bemessende maximale Breite b_{B} des Berührungsbereichs im Bereich von 1 cm bis 14 cm, vorzugsweise im Bereich von 1 cm bis 3 cm, liegt.

7. Scheibenanordnung (101) nach Anspruch 5 und 6, wobei ein Verhältnis der Breite b_{Z} des Zuleitungsbereichs (12) zur maximalen Breite b_{B} des Berührungsbereichs (11) mindestens 1:2, vorzugsweise mindestens 1:10 beträgt.

8. Scheibenanordnung (101) nach einem der Ansprüche 1 bis 7, wobei der Zuleitungsbereich (12) rechteckförmig, streifenförmig oder linienförmig ausgebildet ist.

9. Scheibenanordnung (101) nach einem der Ansprüche 1 bis 8, wobei der Berührungsbereich (11) kreisförmig, elliptisch oder tropfenförmig ausgebildet ist.

10. Scheibenanordnung (101) nach einem der Ansprüche 1 bis 8, wobei der Berührungsbereich (11) eine eckige Form aufweist, vorzugsweise mit gerundeten Ecken, wobei die Ecken vorzugsweisen einen Krümmungsradius von mindestens 3 mm, besonders bevorzugt mindestens 8 mm, aufweisen.

11. Scheibenanordnung (101) nach einem der Ansprüche 1 bis 10, wobei der Berührungsbereich (11) eine Fläche im Bereich von 1 cm² bis 200 cm², vorzugsweise im Bereich von 1 cm² bis 9 cm², aufweist.

12. Scheibenanordnung (101) nach einem der Ansprüche 1 bis 11, wobei eine Breite t₁ der erste Trennlinie (7) und/oder Breite der zweiten Trennlinie (8) im Bereich von 30 µm bis 200 µm, vorzugsweise im Bereich von 70 µm bis 140 µm, liegt.

13. Scheibenanordnung (101) nach einem der Ansprüche 1 bis 12, bei welcher die Scheibe (1) eine Innenscheibe (1) einer Verbundscheibe (110) ist, wobei die Verbundscheibe (110) weiterhin eine Außenscheibe (2) mit einer außenseitigen Oberfläche (I) und einer innenseitigen Oberfläche (II) und mindestens eine Zwischenschicht (2), die die innenseitige Oberfläche (II) der Außenscheibe (2) flächig mit der außenseitigen Oberfläche (III) der Innenscheibe (1) verbindet, umfasst,

14. Scheibenanordnung (101) nach Anspruch 13, wobei die Empfindlichkeit der Sensorelektronik (14) so gewählt ist, dass sie bei Berührung des Berührungsbereichs (11) auf der innenseitigen Oberfläche (IV) der Innenscheibe (1) und/oder der außenseitigen Oberfläche (I) der Außenscheibe (2) mit einem menschlichen Finger ein Schaltsignal ausgibt und bei Berührung des Zuleitungsbereichs (12) auf der innenseitigen Oberfläche (IV) der Innenscheibe (1) und/oder der außenseitigen Oberfläche (I) der Außenscheibe (2) kein Schaltsignal oder ein anderes Schaltsignal ausgibt.

15. Verfahren zur Herstellung einer Scheibenanordnung (101) einem der Ansprüche 1 bis 14, welches die folgenden Schritte umfasst:
(a) Aufbringen einer Low-E-Beschichtung (6) auf die innenseitige Oberfläche (IV) der Scheibe (1),
(b) Einbringen mindestens einer ersten Trennlinie (7) in die Low-E-Beschichtung (6), die die Low-E-Beschichtung (6) in mindestens einen kapazitiven Schaltbereich (10) und mindestens einen Umgebungsbereich (15) elektrisch unterteilt, bevorzugt durch Laserstrukturierung oder durch mechanisches oder chemisches Abtragen,
(c) Einbringen mindestens einer zweiten Trennlinie (8) in die Low-E-Beschichtung (6), bevorzugt durch Laserstrukturierung oder durch mechanisches oder chemisches Abtragen, die den Umgebungsbereich (15) und einen Außenbereich (31) der Low-E-Beschichtung (6) elektrisch unterteilt.

## Claims

1. Pane arrangement (101), comprising:
- a pane (1) with an inner surface (IV) and an outer surface (III),
- a low-E coating (6), which is arranged at least partially on the inner surface (IV) of the pane (1),
- at least one coating-free first partition line (7), which is formed in the low-E coating (6) and by which at least one capacitive switching region (10) is electrically isolated from a surrounding region (15) of the low-E coating (6), wherein the surrounding region (15) surrounds the capacitive switching region (10) at least partially, in particular completely, and wherein the capacitive switching region (10) has a contact region (11), a supply line region (12), and a first connection region (13), wherein the supply line region (12) electrically connects the contact region (11) to the first connection region (13),
- at least one coating-free second partition line (8), which is formed in the low-E coating (6) and by which the surrounding region (15) is electrically isolated from an outer region (31) of the low-E coating (6), wherein the outer region (31) at least partially, in particular completely, surrounds the surrounding region (15),
- a capacitive sensor electronics system (14), which is electrically connected to the first connection region (13) of the capacitive switching region (10) and to the surrounding region (15) by means of a second connection region (16).

2. Pane arrangement (101) according to claim 1, wherein a shortest distance between the first partition line (7) and the second partition line (8) is in the range from 0.1 mm to 200 cm, preferably in the range from 0.5 mm to 100 mm, and particularly preferably in the range from 1 mm to 11 mm.

3. Pane arrangement (101) according to claim 1 or 2, wherein a shortest distance between the first partition line (7) and the second partition line (8) is unchanged in a section of the second partition line (8) surrounding the contact region (11) and/or the supply line region (12) and/or the connection region (13).

4. Pane arrangement (101) according to one of claims 1 through 3, wherein the second partition line (8) surrounds the capacitive switching region (10) like a frame.

5. Pane arrangement (101) according to one of claims 1 through 4, wherein a length I_{Z} of the supply line region (12) is in the range from 1 cm to 70 cm, preferably in the range from 1 cm to 12 cm, particularly preferably in the range from 3 cm to 8 cm, and wherein a width bz of the supply line region (12) to be measured perpendicular to the length I_{Z} is in the range from 0.5 mm to 10 mm, preferably in the range from 0.5 mm to 2 mm, and wherein a ratio of width bz to length I_{Z} of the supply line region (12) is less than or equal to 1:700 and preferably less than or equal to 1:3 to 1:100.

6. Pane arrangement (101) according to one of claims 1 through 5, wherein the contact region (11) has a length I_{B} in the range from 1 cm to 14 cm, preferably in the range from 1 cm to 3 cm, and wherein a maximum width b_{B} of the contact region to be measured perpendicular to the length I_{B} is in the range from 1 cm to 14 cm, preferably in the range from 1 cm to 3 cm.

7. Pane arrangement (101) according to claim 5 and 6, wherein a ratio of the width bz of the supply line region (12) to the maximum width b_{B} of the contact region (11) is at least 1:2, preferably at least 1:10.

8. Pane arrangement (101) according to one of claims 1 through 7, wherein the supply line region (12) is rectangular, strip-shaped, or line-shaped.

9. Pane arrangement (101) according to one of claims 1 through 8, wherein the contact region (11) is circular, elliptical, or drop-shaped.

10. Pane arrangement (101) according to one of claims 1 through 8, wherein the contact region (11) has an angled shape, preferably with rounded corners, wherein the corners preferably have a radius of curvature of at least 3 mm, particularly preferably at least 8 mm.

11. Pane arrangement (101) according to one of claims 1 through 10, wherein the contact region (11) has an area in the range from 1 cm2 to 200 cm², preferably in the range from 1 cm² to 9 cm².

12. Pane arrangement (101) according to one of claims 1 through 11, wherein a width t₁ of the first partition line (7) and/or width of the second partition line (8) is in the range from 30 µm to 200 µm, preferably in the range from 70 µm to 140 µm.

13. Pane arrangement (101) according to one of claims 1 through 12, wherein the pane (1) is an inner pane (1) of a composite pane (110), wherein the composite pane (110) furthermore comprises an outer pane (2) with an outer surface (I) and an inner surface (II) and at least one intermediate layer (2), which bonds the inner surface (II) of the outer pane (2) areally to the outer surface (III) of the inner pane (1).

14. Pane arrangement (101) according to claim 13, wherein the sensitivity of the sensor electronics system (14) is selected such that upon contact of the contact region (11) on the inner surface (IV) of the inner pane (1) and/or the outer surface (I) of the outer pane (2) with a human finger, it emits a switching signal and upon contact of the supply line region (12) on the inner surface (IV) of the inner pane (1) and/or the outer surface (I) of the outer pane (2), it emits no switching signal or a different switching signal.

15. Method for producing a pane arrangement (101) according to one of claims 1 through 14, which comprises the following steps:
(a) applying a low-E coating (6) to the inner surface (IV) of the pane (1),
(b) introducing at least one first partition line (7) into the low-E coating (6), which electrically divides the low-E coating (6) into at least one capacitive switching region (10) and at least one surrounding region (15), preferably by laser patterning or by mechanical or chemical ablation,
(c) introducing at least one second partition line (8) into the low-E coating (6), preferably by laser patterning or by mechanical or chemical ablation, which electrically divides the surrounding region (15) and an outer region (31) of the low-E coating (6).

## Revendications

1. Agencement de vitres (101), comprenant :
- une vitre (1) avec une surface intérieure (IV) et une surface extérieure (III),
- un revêtement à faible émissivité (6), qui est disposé au moins partiellement sur la surface intérieure (IV) de la vitre (1),
- au moins une première ligne de séparation (7) sans revêtement, qui est formée dans le revêtement à faible émissivité (6) et par laquelle au moins une zone de commutation capacitive (10) est isolée électriquement d'une zone environnante (15) du revêtement à faible émissivité (6), la zone environnante (15) entourant au moins partiellement la zone de commutation capacitive (10), en particulier complètement, et dans lequel la zone de commutation capacitive (10) présente une zone de contact (11), une zone de ligne d'alimentation (12) et une première zone de raccordement (13), la zone de ligne d'alimentation (12) reliant électriquement la zone de contact (11) à la première zone de raccordement (13),
- au moins une deuxième ligne de séparation (8) sans revêtement, qui est formée dans le revêtement à faible émissivité (6) et par laquelle la zone environnante (15) est isolée électriquement d'une zone extérieure (31) du revêtement à faible émissivité (6), la zone extérieure (31) entourant au moins partiellement, en particulier complètement, la zone environnante (15),
- un système électronique de capteur capacitif (14), qui est relié électriquement à la première zone de raccordement (13) de la zone de commutation capacitive (10) et à la zone environnante (15) au moyen d'une deuxième zone de raccordement (16).

2. Agencement de vitres (101) selon la revendication 1, dans lequel la distance la plus courte entre la première ligne de séparation (7) et la deuxième ligne de séparation (8) se situe dans la plage de 0,1 mm à 200 cm, de préférence dans la plage de 0,5 mm à 100 mm, et en particulier de préférence dans la plage de 1 mm à 11 mm.

3. Agencement de vitres (101) selon la revendication 1 ou 2, dans lequel une distance la plus courte entre la première ligne de séparation (7) et la deuxième ligne de séparation (8) est inchangée dans une section de la deuxième ligne de séparation (8) entourant la zone de contact (11) et/ou la zone de ligne d'alimentation (12) et/ou la zone de raccordement (13).

4. Agencement de vitres (101) selon l'une des revendications 1 à 3, dans laquelle la deuxième ligne de séparation (8) entoure la zone de commutation capacitive (10) comme un cadre.

5. Agencement de vitres (101) selon l'une des revendications 1 à 4, dans lequel une longueur I_{Z} de la zone de ligne d'alimentation (12) est comprise dans la plage de 1 cm à 70 cm, de préférence dans la plage de 1 cm à 12 cm, de manière particulièrement préférée dans la plage de 3 cm à 8 cm, et dans lequel une largeur bz de la zone de ligne d'alimentation (12) à mesurer perpendiculairement à la longueur I_{Z} est comprise dans la plage de 0,5 mm à 10 mm, de préférence dans la plage de 0,5 mm à 2 mm, et dans lequel un rapport de la largeur bz à la longueur I_{Z} de la région de la ligne d'alimentation (12) est inférieur ou égal à 1:700 et de préférence inférieur ou égal à 1:3 à 1:100.

6. Agencement de vitres (101) selon l'une des revendications 1 à 5, dans lequel la région de contact (11) a une longueur I_{B} dans la plage de 1 cm à 14 cm, de préférence dans la plage de 1 cm à 3 cm, et dans lequel une largeur maximale b_{B} de la région de contact à mesurer perpendiculairement à la longueur I_{B} est dans la plage de 1 cm à 14 cm, de préférence dans la plage de 1 cm à 3 cm.

7. Agencement de vitres (101) selon les revendications 5 et 6, dans lequel un rapport de la largeur bz de la zone de conduite d'alimentation (12) à la largeur maximale b_{B} de la zone de contact (11) est d'au moins 1:2, de préférence d'au moins 1:10.

8. Agencement de vitres (101) selon l'une des revendications 1 à 7, dans laquelle la zone de la ligne d'alimentation (12) est rectangulaire, en forme de bande ou en forme de ligne.

9. Agencement de vitres (101) selon l'une des revendications 1 à 8, dans lequel la zone de contact (11) est circulaire, elliptique ou en forme de goutte.

10. Agencement de vitres (101) selon l'une des revendications 1 à 8, dans lequel la zone de contact (11) a une forme angulaire, de préférence avec des coins arrondis, dans lequel les coins ont de préférence un rayon de courbure d'au moins 3 mm, en particulier de préférence d'au moins 8 mm.

11. Agencement de vitres (101) selon l'une des revendications 1 à 10, dans lequel la zone de contact (11) a une surface dans la plage de 1 cm² à 200 cm², de préférence dans la plage de 1 cm² à 9 cm².

12. Agencement de vitres (101) selon l'une des revendications 1 à 11, dans lequel une largeur t₁ de la première ligne de séparation (7) et/ou une largeur de la deuxième ligne de séparation (8) se situe dans la plage de 30 µm à 200 µm, de préférence dans la plage de 70 µm à 140 µm.

13. Agencement de vitres (101) selon l'une des revendications 1 à 12, dans lequel la vitre (1) est une vitre intérieure (1) d'une vitre composite (110), dans lequel la vitre composite (110) comprend en outre une vitre extérieure (2) avec une surface extérieure (I) et une surface intérieure (II) et au moins une couche intermédiaire (2), qui relie la surface intérieure (II) de la vitre extérieure (2) de manière plane à la surface extérieure (III) de la vitre intérieure (1).

14. Agencement de vitres (101) selon la revendication 13, dans lequel la sensibilité du système électronique de capteur capacitif (14) est choisie de telle sorte que, lors d'un contact de la zone de contact (11) sur la surface intérieure (IV) de la vitre intérieure (1) et/ou la surface extérieure (I) de la vitre extérieure (2) avec un doigt humain, elle émet un signal de commutation et, lors d'un contact de la zone de ligne d'alimentation (12) sur la surface intérieure (IV) de la vitre intérieure (1) et/ou la surface extérieure (I) de la vitre extérieure (2), elle n'émet aucun signal de commutation ou un signal de commutation différent.

15. Procédé de fabrication d'un agencement de vitres (101) selon l'une des revendications 1 à 14, qui comprend les étapes suivantes :
(a) application d'un revêtement à faible émissivité (6) sur la surface intérieure (IV) de la vitre (1),
b) l'introduction d'au moins une première ligne de séparation (7) dans le revêtement à faible émissivité (6), qui divise électriquement le à faible émissivité (6) en au moins une zone de commutation capacitive (10) et au moins une zone environnante (15), de préférence par structuration au laser ou par ablation mécanique ou chimique,
c) introduire au moins une deuxième ligne de séparation (8) dans le revêtement à faible émissivité (6), de préférence par structuration au laser ou par ablation mécanique ou chimique, qui divise électriquement la région environnante (15) et une région extérieure (31) du revêtement à faible émissivité (6).
